# EUROPEAN PATENT SPECIFICATION

(11) **EP 3 099 649 B1**
(45) Date of publication and mention of the grant of the patent: **25.07.2018**
(21) Application number: 15706548.3
(22) Date of filing: 15.01.2015
(51) Int. Cl.: C04B 35/495, H01L 41/187, H04N 5/217, H01L 41/083, H02N 2/10, H02N 2/16, B41J 2/14, H01L 41/43, H01L 41/047, B06B 1/06

(54) **PIEZOELECTRIC CERAMIC, METHOD FOR PRODUCING THE SAME, PIEZOELECTRIC ELEMENT, MULTILAYER PIEZOELECTRIC ELEMENT, LIQUID EJECTION HEAD, LIQUID EJECTING APPARATUS, ULTRASONIC MOTOR, OPTICAL DEVICE, VIBRATING APPARATUS, DUST-REMOVING APPARATUS, IMAGING APPARATUS, AND ELECTRONIC DEVICE**
PIEZOELEKTRISCHE KERAMIK, VERFAHREN ZUR HERSTELLUNG DAVON, PIEZOELEKTRISCHES ELEMENT, MEHRSCHICHTIGES PIEZOELEKTRISCHES ELEMENT, FLÜSSIGKEITSAUSSTOSSKOPF, FLÜSSIGKEITSAUSSTOSSVORRICHTUNG, ULTRASCHALLMOTOR, OPTISCHE VORRICHTUNG, SCHWINGUNGSVORRICHTUNG, STAUBENTFERNUNGSVORRICHTUNG, BILDGEBUNGSVORRICHTUNG UND ELEKTRONISCHE VORRICHTUNG
CÉRAMIQUE PIÉZOÉLECTRIQUE, PROCÉDÉ DE PRODUCTION ASSOCIÉ, ÉLÉMENT PIÉZOÉLECTRIQUE, ÉLÉMENT PIÉZOÉLECTRIQUE MULTICOUCHE, TÊTE D'ÉJECTION LIQUIDE, APPAREIL D'ÉJECTION LIQUIDE, MOTEUR ULTRASONORE, DISPOSITIF OPTIQUE, APPAREIL VIBRANT, APPAREIL DE DÉPOUSSIÉRAGE, APPAREIL D'IMAGERIE ET DISPOSITIF ÉLECTRONIQUE

(30) Priority: 29.01.2014 JP 2014014471
(43) Date of publication of application: 07.12.2016
(73) Proprietor: Canon Kabushiki Kaisha, Tokyo 146-8501 (JP)
(72) Inventor: WATANABE, Takayuki, Tokyo 146-8501 (JP); UEDA, Miki, Tokyo 146-8501 (JP); HAYASHI, Jumpei, Tokyo 146-8501 (JP); MIURA, Kaoru, Tokyo 146-8501 (JP)
(74) Representative: WESER & Kollegen
(86) International application number: PCT/JP2015/051588
(87) International publication number: WO 2015/115279

(56) References cited:
- EP-A1- 1 630 149
- WO-A1-2012/118213
- WO-A1-2013/062120
- CN-A- 101 066 868
- JP-A- 2012 162 408

## Description

### Technical Field

The present invention relates to a piezoelectric ceramic and more specifically to a lead-free piezoelectric ceramic and a method for producing such a piezoelectric ceramic. The present invention also relates to a piezoelectric element, a multilayer piezoelectric element, a liquid ejection head, a liquid ejecting apparatus, an ultrasonic motor, an optical device, a vibrating apparatus, a dust-removing apparatus, an imaging apparatus, and an electronic device that include the piezoelectric ceramic.

### Background Art

ABO₃ perovskite-type metal oxides such as lead zirconate titanate (hereinafter, referred to as "PZT") have been generally used as piezoelectric ceramics. However, there has been a concern about the negative impact of PZT on the environment because PZT contains lead at the A-site. Accordingly, a lead-free piezoelectric ceramic that includes a perovskite-type metal oxide has been anticipated.

It is described in NPL 1 that, dissolving a small amount of barium titanate in sodium niobate in the form of a solid changes sodium niobate from antiferroelectric to ferroelectric. NPL 1 discloses the relative dielectric constant εᵣ, dielectric tangent tan D, double the remanent polarization 2Pᵣ, double the coercive electric field 2E_{c}, Curie temperature T_{c}, piezoelectric constant d₃₃, and electromechanical coupling coefficients kₚ and kₜ of a piezoelectric ceramic that includes barium titanate at a concentration of 5% to 20%, which has been sintered at 1200°C to 1280°C. The piezoelectric material described in NPL 1 contains neither lead nor potassium that deteriorates sinterability and moisture resistance. The piezoelectric material described in NPL 1 has a higher Curie temperature than barium titanate (110°C to 120°C), which is a common lead-free piezoelectric material. The Curie temperature of the piezoelectric material described in NPL 1 is 230°C when the piezoelectric material has a composition (Na_{0.9}Ba_{0.1})(Nb_{0.9}Ti_{0.1})O₃, at which the piezoelectric material has a maximum piezoelectric constant d₃₃ of 143 pC/N.

NPL 2 discloses the relative density, grain size, piezoelectric constant d₃₃, electromechanical coupling coefficient kₚ, mechanical quality factor Qₘ, frequency constant N_{d}, relative dielectric constant εᵣ, dielectric tangent tan D, and the dependence of the electric field-polarization hysteresis curve for the Cu-doped (Na_{0.9}Ba_{0.1})(Nb_{0.9}Ti_{0.1})O₃ piezoelectric ceramics sintered at 1265°C (Figs. 2 to 7 of NPL 2). In NPL 2, Fig. 3 shows that the size of grains of the ceramic increases with an increase in the amount of copper added, and Fig. 5 shows that the addition of copper increases Qₘ from about 275 to about 375.

It is described in PTL 1 that adding cobalt to a piezoelectric ceramic that is a solid solution of barium titanate and sodium niobate increases the piezoelectric constant of the piezoelectric ceramic. It is also described in PTL 1 that, while a piezoelectric ceramic having a composition at which the piezoelectric constant d₃₁ becomes low (12 pC/N) has a mechanical quality factor Qₘ of 1020, a piezoelectric ceramic having a composition at which the piezoelectric constant d₃₁ becomes high (54 to 56 pC/N) has a lower mechanical quality factor Qₘ of 250 to 430. It is also described in PTL 1 that some samples of the piezoelectric material described in PTL 1 had too low insulation resistance (10⁶ Ω or less) to perform poling treatment.

### Citation List

### Patent Literature

PTL 1 Japanese Patent Laid-Open No. 2009-227535

### Non Patent Literature

NPL 1 J. T. Zeng et al., Journal of the American Ceramic Society, 2006, Vol. 89, pp. 2828-2832
NPL 2 K. Zhu et al., Journal of the Chinese Ceramic Society, 2010, Vol. 38, pp. 1031-1035

### Summary of Invention

### Technical Problem

The mechanical quality factor of the piezoelectric material of the related art, which is a solid solution of barium titanate and sodium niobate (hereinafter, referred to as "SN-BT"), becomes low when the piezoelectric material has a composition at which the piezoelectric constant of the piezoelectric material becomes high. In order to increase the mechanical quality factor, use of copper or cobalt has been needed. However, .cobalt is expensive, and the potential harm that cobalt can cause has been pointed out. In addition, the insulation resistance of SN-BT including cobalt is not sufficiently high.

Accordingly, the present invention is directed to providing a piezoelectric ceramic that does not contain any of lead, potassium, and cobalt and has a high Curie temperature, a high mechanical quality factor, and good piezoelectric properties and a method for producing the piezoelectric ceramic. The present invention is also directed to providing a piezoelectric element, a multilayer piezoelectric element, a liquid ejection head, a liquid ejecting apparatus, an ultrasonic motor, an optical device, a vibrating apparatus, a dust-removing apparatus, an imaging apparatus, and an electronic device that include the piezoelectric ceramic.

### Solution to Problem

According to a first aspect of the present invention, there is provided a piezoelectric ceramic comprising a perovskite-type metal oxide represented by General Formula (1) below; CuO; and MgO. In the piezoelectric ceramic, the content of CuO is 0.1 mol% or more and 1 mol% or less and the content of MgO is 0.1 mol% or more and 2 mol% or less of the content of the perovskite-type metal oxide.

General Formula (1): (NaₓBa_{1-y})(Nb_{y}Ti_{1-y})O₃,

where 0.85 ≤ x ≤ 0.92, 0.85 ≤ y ≤ 0.92, and 0.95 ≤ x/y ≤ 1.05.

According to a second aspect of the present invention, there is provided a method for producing the above-described piezoelectric ceramic, the method comprising sintering a raw material powder including Na, Nb, Ba, Ti, Cu, and Mg. The molar ratio of Na to Nb included in the raw material powder is 0.95 ≤ Na/Nb ≤ 1.10.

According to a third aspect of the present invention, there is provided a piezoelectric element comprising a first electrode; a piezoelectric material portion; and a second electrode. The piezoelectric material portion includes the above-described piezoelectric ceramic.

According to a fourth aspect of the present invention, there is provided a multilayer piezoelectric element comprising a plurality of piezoelectric ceramic layers; and a plurality of electrode layers each including an internal electrode. The piezoelectric ceramic layers and the electrode layers are alternately stacked on top of one another. The piezoelectric ceramic layers each include the above-described piezoelectric ceramic.

According to a fifth aspect of the present invention, there is provided a liquid ejection head comprising a liquid chamber including a vibrating portion in which the above-described piezoelectric element or the above-described multilayer piezoelectric element is disposed; and an ejection port communicating with the liquid chamber.

According to a sixth aspect of the present invention, there is provided a liquid ejecting apparatus comprising a recording-medium transportation section; and the above-described liquid ejection head.

According to a seventh aspect of the present invention, there is provided an ultrasonic motor comprising a vibrating body in which the above-described piezoelectric element or the above-described multilayer piezoelectric element is disposed; and a moving body in contact with the vibrating body.

According to an eighth aspect of the present invention, there is provided an optical device comprising a driving section including the above-described ultrasonic motor.

According to a ninth aspect of the present invention, there is provided a vibrating apparatus comprising a vibrating body including a vibrating plate on which the above-described piezoelectric element or the above-described multilayer piezoelectric element is disposed.

According to a tenth aspect of the present invention, there is provided a dust-removing apparatus comprising a vibrating portion including the above-described vibrating apparatus.

According to an eleventh aspect of the present invention, there is provided an imaging apparatus comprising the above-described dust-removing apparatus; and an imaging-element unit. The vibrating plate of the dust-removing apparatus is disposed on a light-receiving-side surface of the imaging-element unit.

According to a twelfth aspect of the present invention, there is provided an electronic device comprising a piezoelectric acoustic component comprising the above-described piezoelectric element or the above-described multilayer piezoelectric element.

Further features of the present invention will become apparent from the following description of exemplary embodiments with reference to the attached drawings.

According to aspects of the present invention, a piezoelectric ceramic that does not contain any of lead, potassium, and cobalt and has a high Curie temperature, a high mechanical quality factor, and good piezoelectric properties and a method for producing the piezoelectric ceramic may be provided. According to other aspects of the present invention, a piezoelectric element, a multilayer piezoelectric element, a liquid ejection head, a liquid ejecting apparatus, an ultrasonic motor, an optical device, a vibrating apparatus, a dust-removing apparatus, an imaging apparatus, and an electronic device that include the piezoelectric ceramic may be provided.

The piezoelectric ceramic according to an aspect of the present invention has a low environmental load since it does not contain lead and also has good sinterability and high moisture resistance since it does not contain potassium.

### Brief Description of Drawings

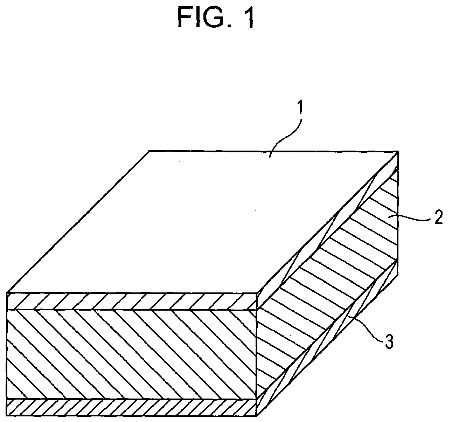

Fig. 1 is a diagram schematically illustrating a piezoelectric element according to an embodiment of the present invention.

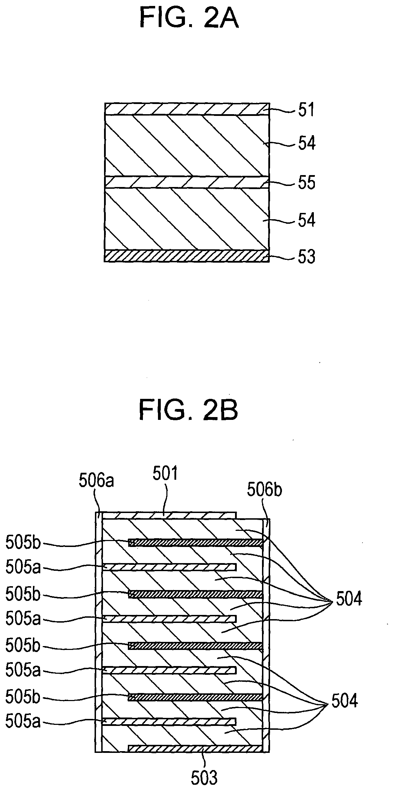

Figs. 2A and 2B are schematic cross-sectional views of examples of a multilayer piezoelectric element according to an embodiment of the present invention.

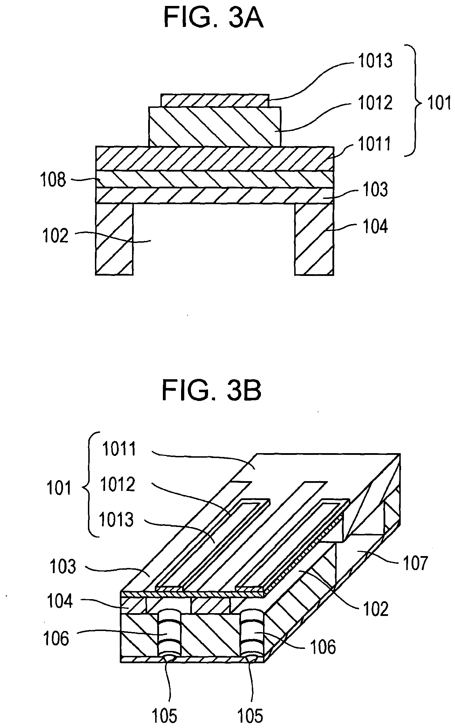

Figs. 3A and 3B are diagrams schematically illustrating a liquid ejection head according to an embodiment of the present invention.

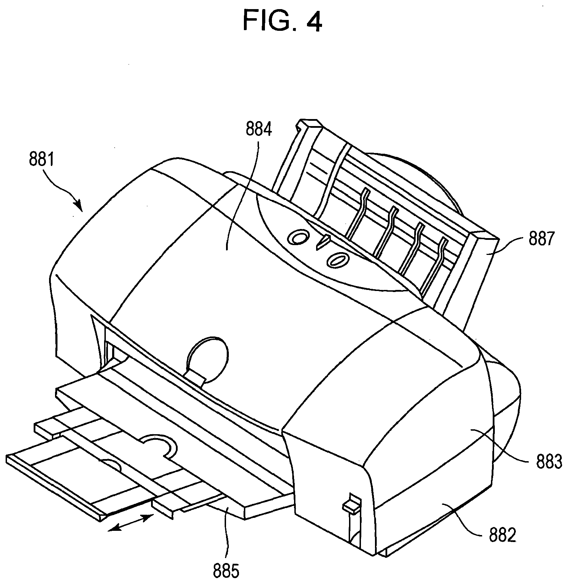

Fig. 4 is a diagram schematically illustrating a liquid ejecting apparatus according to an embodiment of the present invention.

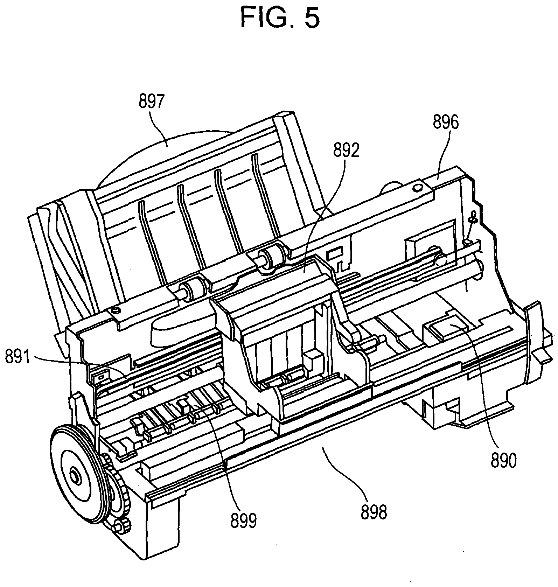

Fig. 5 is a diagram schematically illustrating a liquid ejecting apparatus according to another embodiment of the present invention.

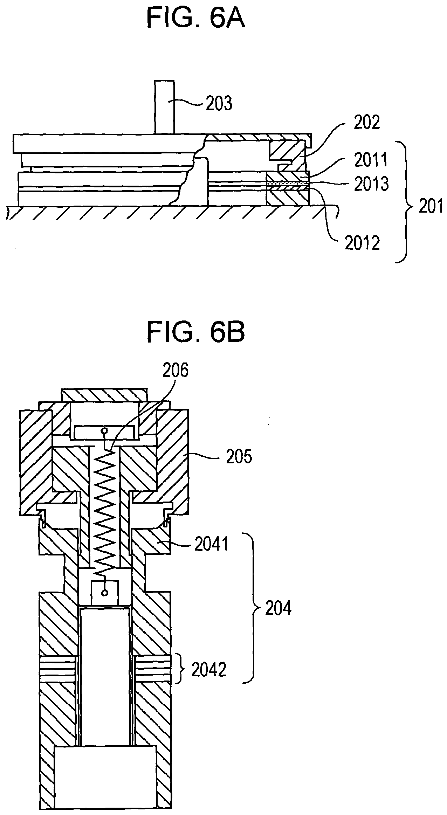

Figs. 6A and 6B are diagrams schematically illustrating examples of an ultrasonic motor according to an embodiment of the present invention.

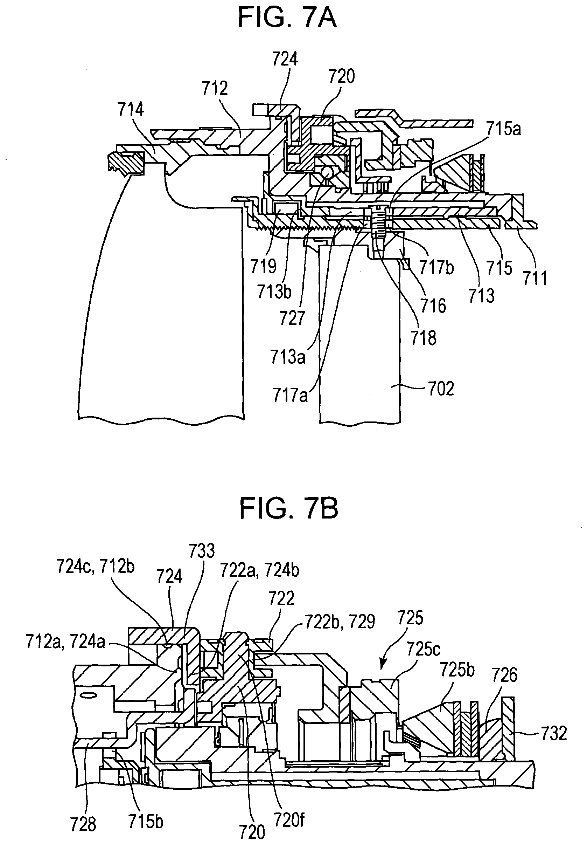

Figs. 7A and 7B are diagrams schematically illustrating an optical device according to an embodiment of the present invention.

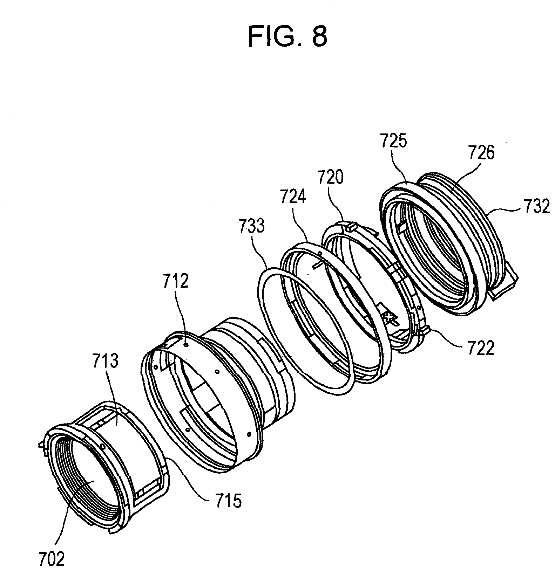

Fig. 8 is a diagram schematically illustrating an optical device according to another embodiment of the present invention.

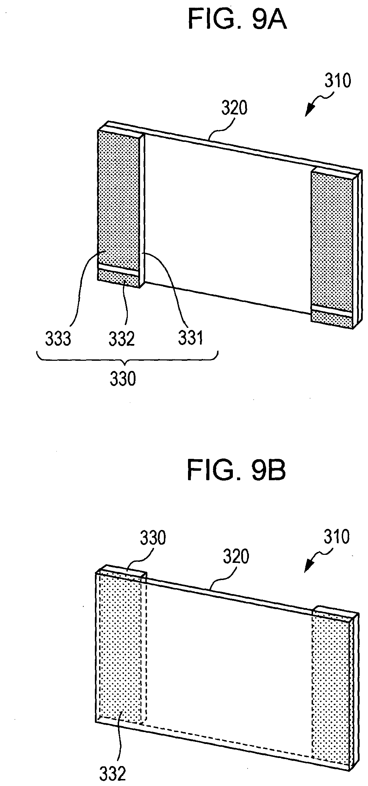

Figs. 9A and 9B are diagrams schematically illustrating a dust-removing apparatus that includes a vibrating apparatus according to an embodiment of the present invention.

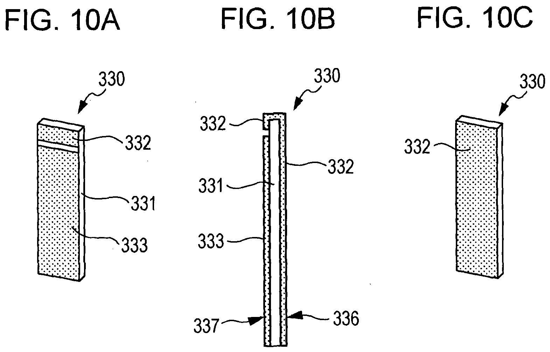

Figs. 10A to 10C are diagrams schematically illustrating a piezoelectric element according to an embodiment of the present invention which is included in a dust-removing apparatus.

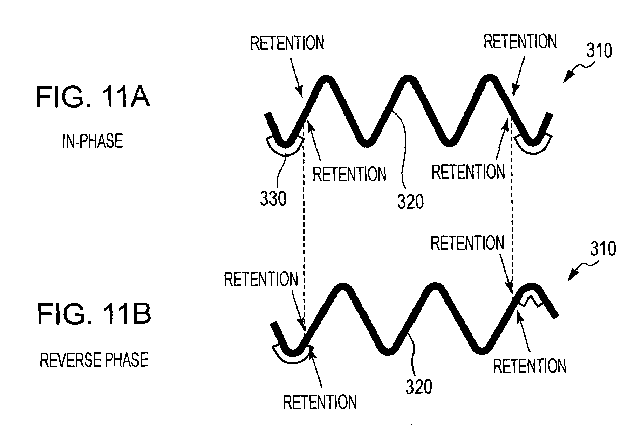

Figs. 11A and 11B are diagrams schematically illustrating the principle of vibration of a dust-removing apparatus according to an embodiment of the present invention.

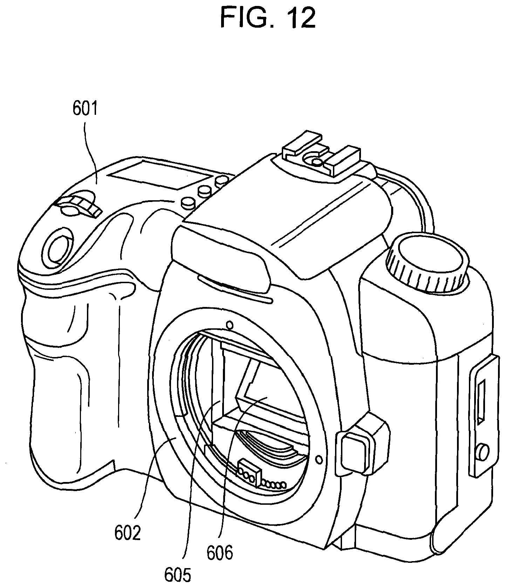

Fig. 12 is a diagram schematically illustrating an imaging apparatus according to an embodiment of the present invention.

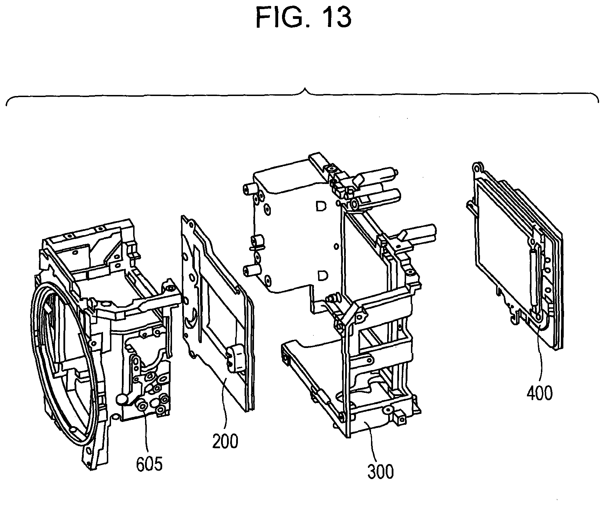

Fig. 13 is a diagram schematically illustrating an imaging apparatus according to another embodiment of the present invention.

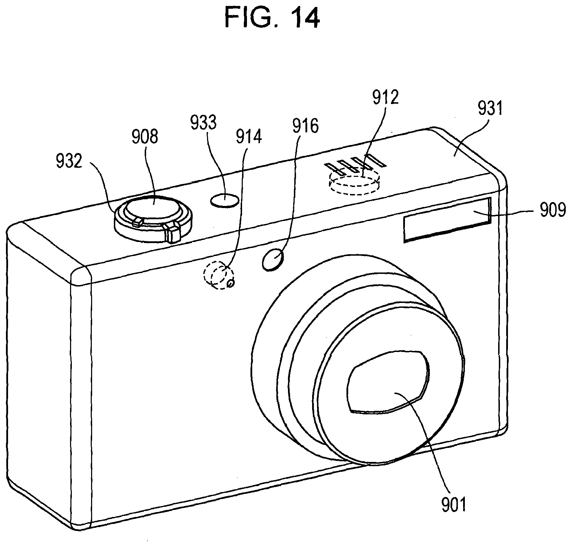

Fig. 14 is a diagram schematically illustrating an electronic device according to an embodiment of the present invention.

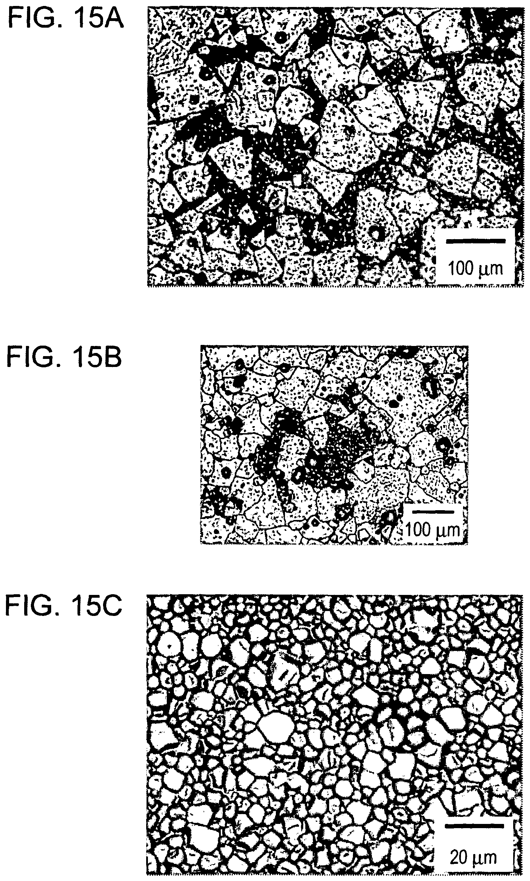

Figs. 15A to 15C are optical microscope images of the surfaces of piezoelectric ceramics prepared in Comparative Example 3, Example 1, and Example 2, respectively.

### Description of Embodiments

Embodiments of the present invention are described below.

The present invention is directed to providing a lead-free piezoelectric ceramic which includes a solid solution of barium titanate and sodium niobate (SN-BT) with a high Curie temperature, a high mechanical quality factor, and good piezoelectric properties. The piezoelectric ceramic according to an embodiment of the present invention may be used in various applications such as capacitors, memories, and sensors by taking advantage of its characteristics as a dielectric material.

The piezoelectric ceramic according to the embodiment includes a perovskite-type metal oxide represented by General Formula (1) below; CuO; and MgO. In the piezoelectric ceramic, the content of CuO is 0.1 mol% or more and 1 mol% or less and the content of MgO is 0.1 mol% or more and 2 mol% or less of the content of the perovskite-type metal oxide.

General Formula (1): (NaₓBa_{1-y})(Nb_{y}Ti_{1-y})O₃,

where 0.85 ≤ x ≤ 0.92, 0.85 ≤ y ≤ 0.92, and 0.95 ≤ x/y ≤ 1.05.

The term "perovskite-type metal oxide" used herein refers to a metal oxide having a perovskite-type structure (also referred to as "perovskite structure"), which is ideally a cubic crystal structure, as described in Iwanami Rikagaku Jiten (Iwanami's Dictionary of Physics and Chemistry) 5th Edition (Published by Iwanami Shoten, Publishers. on February 20, 1998). Metal oxides having a perovskite structure are generally expressed by a chemical formula ABO₃. The elements A and B occupy particular positions of the unit cell of the perovskite-type metal oxide, namely, the A-site and B-site, respectively, in the form of ions. For example, in the unit cell of a cubic crystal system, an A-site element occupies the corner of the cube, a B-site element occupies the body center of the cube, and O sits at face-centered positions of the cube in the form of oxygen anions. A-site elements are in 12-fold coordination, and B-site elements are in 6-fold coordination.

In a metal oxide represented by General Formula (1) above, an element that occupies the A-site is Na or Ba, and an element that occupies the B-site is Ti or Nb. However, some Na or Ba may occupy the B-site. Similarly, some Ti or Nb may occupy the A-site.

Although the molar ratio of the B-site elements to the O elements in General Formula (1) is 1:3, the scope of the present invention still covers any metal oxide having a perovskite structure as a main phase even when the molar ratio deviates slightly from 1:3 (e.g., 1.00:2.94 to 1.00:3.06). Whether the metal oxide has a perovskite structure can be determined by analyzing the structure of the metal oxide using, for example, X-ray diffraction or electron diffraction.

The term "ceramic" used herein refers to an aggregate (also referred to as "sintered body") of crystal grains obtained via sintering process, that is, a polycrystal, which includes a metal oxide as a fundamental component. The term "ceramic" used herein still covers the one that has been processed after being sintered.

General Formula (1) above represents a composition of a perovskite-type metal oxide that contains y moles of Na_{x/y}NbO₃ and 1-y moles of BaTiO₃. The perovskite-type metal oxide represented by General Formula (1) above is a solid solution of BaTiO₃ and NaNbO₃, which is produced by dissolving barium titanate in sodium niobate in the form of a solid. The molar ratio of Na to Nb contained in the solid solution (Na/Nb) may become greater than 1 depending on the compositions of the raw material powders used and the amounts of raw material powders weighed. On the other hand, the ratio Na/Nb may become less than 1 when Na volatilizes during calcining or sintering process. Thus, in General Formula (1), the index for Na is represented by "x" as distinguished from the index "y" for Nb considering cases where the Na content in the piezoelectric ceramic according to the embodiment may be excessively higher than or lower than the Nb content in the piezoelectric ceramic.

In General Formula (1), x ranges 0.85 ≤ x ≤ 0.92. If the Na content x is less than 0.85, the Curie temperature of the piezoelectric ceramic becomes lower than 120°C. If the Na content x is more than 0.92, the piezoelectric properties of the piezoelectric ceramic become degraded. Preferably, x ranges 0.85 ≤ x ≤ 0.90.

In General Formula (1), y ranges 0.85 ≤ y ≤ 0.92. If the Nb content y is less than 0.85, the Curie temperature of the piezoelectric ceramic becomes lower than 120°C. If the Nb content y exceeds 0.92, the piezoelectric properties of the piezoelectric ceramic become degraded. Preferably, y ranges 0.85 ≤ y ≤ 0.90.

In General Formula (1), the ratio x/y of the Na content x to the Nb content y ranges 0.95 ≤ x/y ≤ 1.05. If the Na content is lower than the Nb content by more than 5%, a phase having an X-ray diffraction pattern similar to those of Ba₄Nb₂O₉, Ba₆Ti₇Nb₉O₄₂, Ba₃Nb₄Ti₄O₂₁, Ba₃Nb_{3.2}Ti₅O₂₁, and the like (hereinafter, referred to as "impurity phase") may occur in the piezoelectric ceramic, which reduces the electromechanical coupling coefficient of the piezoelectric ceramic. If the Na content is higher than the Nb content by more than 5%, the mechanical quality factor and insulating property of the piezoelectric ceramic may be degraded. When the ratio x/y of the Na content x to the Nb content y falls within 0.95 ≤ x/y ≤ 1.05, the risk of the occurrence of the impurity phase may be reduced, which allows a piezoelectric ceramic having a good insulating property, that is, good piezoelectric properties, to be produced.

In the piezoelectric ceramic according to the embodiment, the content of CuO is 0.1 mol% or more and 1.00 mol% or less of the content of the perovskite-type metal oxide represented by General Formula (1) above. Adding CuO to the piezoelectric ceramic enhances the piezoelectric properties of the piezoelectric ceramic and lowers the sintering temperature of the piezoelectric ceramic. In the piezoelectric ceramic according to the embodiment, the content of CuO is preferably 0.1 mol% or more and 0.5 mol% or less of the content of the perovskite-type metal oxide represented by General Formula (1) above. When the CuO content falls within the above range, the piezoelectric ceramic has a higher piezoelectric constant by 10% or more than a piezoelectric ceramic that does not include CuO. The lower the sintering temperature of the piezoelectric ceramic, the more significant an increase in the piezoelectric constant of the piezoelectric ceramic caused by the addition of CuO.

In the piezoelectric ceramic according to the embodiment, the content of MgO is 0.1 mol% or more and 2.00 mol% or less of the content of the perovskite-type metal oxide represented by General Formula (1). If the MgO content exceeds 2.00 mol% of the content of the perovskite-type metal oxide, the piezoelectric properties of the piezoelectric ceramic may be degraded. If the MgO content is less than 0.1 mol% of the content of the perovskite-type metal oxide, the mechanical quality factor of the piezoelectric ceramic cannot be increased.

Cu and Mg may be present at the A-site (12-coordination), the B-site (6-coordination), or both the A-site and the B-site of the perovskite structure. In another case, Cu and Mg may be present at the grain boundaries of the ceramic.

Having a low melting point, Cu and CuO promote liquid-phase sintering. This may cause segregation of Cu or CuO at the grain boundaries. Promotion of liquid-phase sintering reduces the numbers of pores formed in the sintered body, thereby increasing the density of the sintered body. A reduction in the numbers of the pores leads to increases in the mechanical quality factor and Young's modulus of the piezoelectric ceramic.

When the B-site is replaced by Cu or Mg, an internal electric field occurs inside the piezoelectric ceramic after the piezoelectric ceramic has been poled. The presence of the internal electric field suppresses the oscillation of the domain wall caused by an external electric field, which increases the mechanical quality factor of the piezoelectric ceramic. The internal electric field can be evaluated by determining a polarization-electric field hysteresis curve. On the basis of the hysteresis curve determined, a coercive electric field (+Ec) at which the spontaneous polarization is switched from negative to positive and a coercive electric field (-Ec) at which the spontaneous polarization is switched from positive to negative can be determined. The magnitudes of +Ec and - Ec are equal to each other when the internal electric field is absent. When the internal electric field is present, the center of the hysteresis curve shifts in the direction of the x-axis (axis of electric field). The magnitude of the internal electric field is calculated as the average of +Ec and -Ec. The hysteresis curve may be determined using a commercially available ferroelectric evaluation system. Generally, the hysteresis curve is determined by applying a triangular-wave alternating electric field or a sine-wave alternating electric field to a sample. The hysteresis curve is centered using software so that the average of polarizations measured when the maximum positive and negative electric fields are applied to the sample is aligned to zero of the y-axis. The distributions of Cu and Mg and the sites Cu or Mg occupies in a sample may also be evaluated using an electron microscope, an energy dispersive X-ray spectrometer, an X-ray diffractometer, Raman scattering, or a transmission electron microscope.

In order to prevent the piezoelectric ceramic according to the embodiment from being depoled due to heating during the device preparation or due to heat generated during the device operation, it is preferable to select the composition of the piezoelectric ceramic according to the embodiment so that the Curie temperature of the piezoelectric ceramic is 120°C or more, is preferably 125°C or more, and is more preferably 130°C or more. The Curie temperature of the piezoelectric ceramic according to the embodiment can be controlled by changing the composition parameters x and y, the contents of Cu and Mg, and the microscale compositional uniformity in the piezoelectric material.

The term "Curie temperature" used herein refers to a Curie temperature estimated on the basis of the Curie-Weiss law and also a temperature at which dielectric constant becomes locally maximum in the vicinity of the phase-transition temperature between the ferroelectric phase and the paraelectric phase (cubic phase).

In order to make it easy to produce the piezoelectric ceramic according to the embodiment or to control the physical properties of the piezoelectric ceramic, some of Ba may be replaced by a divalent element, such as Sr or Ca. Similarly, some of Nb may be replaced by a pentavalent element, such as Ta or V, as long as the content of the pentavalent element is 20 mol% or less. Similarly, some of Ti may be replaced by Zr or Sn as long as the content of Zr or Sn is 20 mol% or less, and some of Na may be replaced by Li as long as the content of Li is 15 mol%. Similarly, at least one element selected from Mn, Ni, and Zn may be added at a content of 5 mol% or less of the content of the perovskite-type metal oxide represented by General Formula (1). Similarly, at least one element selected from La, Ce, Pr, Nd, Pm, Sm, Eu, Gd, Tb, Dy, Ho, Er, Tm, and Yb may be added at a content of 5 mol% or less of the content of the perovskite-type metal oxide represented by General Formula (1). Similarly, a sintering aid including at least one element selected from Si and B may be added, on a metal basis, in an amount of 0.001 parts by weight or more and 4.000 parts by weight or less relative to 100 parts by weight of the piezoelectric ceramic.

A method for producing the piezoelectric ceramic according to the embodiment includes sintering a raw material powder including at least Na, Nb, Ba, Ti, Cu, and Mg. The molar ratio of Na to Nb included in the raw material powder is 0.95 ≤ Na/Nb ≤ 1.10.

In the production of the piezoelectric ceramic according to the embodiment, a compact is prepared. The compact is a solid prepared by compacting a raw material powder that has not yet been sintered. The raw material powder preferably has a high purity. The raw material may include a powder or a liquid of the metal oxide or a metal salt constituting the piezoelectric ceramic. The raw material powder may include a powder of a perovskite-type metal oxide, such as a barium titanate powder or a sodium niobate powder. Powders of various copper compounds such as copper oxide (I), copper oxide (II), copper carbonate, copper acetate (II), and copper oxalate may be used as a Cu component. Powders of magnesium compounds such as magnesium oxide may be used as a Mg component.

Examples of a method for compacting the raw material powder include uniaxial pressing, cold isostatic pressing, hot isostatic pressing, casting, and extrusion. The compact may be prepared from a granulated powder. A compact prepared from a granulated powder is advantageous in that, after such a compact has been sintered, the size distribution of crystal grains in the sintered body is likely to be uniform.

The method for granulating the raw material powder of the piezoelectric ceramic may be, but not particularly limited to, a spray dry method in order to achieve higher uniformity of the grain size of the granulated powder.

Examples of a binder used for granulating the raw material powder include polyvinyl alcohol (PVA), polyvinyl butyral (PVB), and acrylic resins. The amount of binder added is preferably 1 to 10 parts by weight and is more preferably, in order to increase the density of the compact, 2 to 5 parts by weight relative to 100 parts by weight of the above-described raw material powders of the piezoelectric ceramic.

Examples of a method for sintering the compact include, but are not particularly limited to, sintering using an electric furnace, sintering using a gas furnace, electric heating, microwave sintering, millimeter-wave sintering, and hot isostatic pressing (HIP). The electric furnace and the gas furnace used for sintering may be either a continuous furnace or a batch furnace.

The sintering temperature is not particularly limited. The piezoelectric ceramic according to the embodiment, which is produced by mixing Cu and Mg with SN-BT, has sufficient piezoelectric properties even when the piezoelectric ceramic has been processed at a low temperature. For example, while a piezoelectric ceramic of the related art which is composed of SN-BT has a sufficiently high density and sufficient piezoelectric properties only when the sintering temperature is 1280°C or more, the piezoelectric ceramic according to the embodiment has a sufficiently high density and sufficient piezoelectric properties even when the sintering temperature is 1200°C or less.

In order to produce a piezoelectric ceramic having consistent properties with good reproducibility by sintering, sintering is preferably performed for 2 hours or more and 48 hours or less at a constant temperature within the above-described sintering temperature range. A sintering method such as two-step sintering may be employed. However, considering productivity, a sintering method in which the temperature is not suddenly changed is preferably employed.

The size of crystal grains of the piezoelectric ceramic according to the embodiment is preferably 0.5 µm or more and 20 µm or less in terms of average equivalent circle diameter. If the average diameter exceeds 20 µm, an adequate strength for a cutting process and a grinding process may not be ensured. If the average diameter is less than 0.5 µm, the piezoelectric properties of the piezoelectric ceramic may be degraded. When the average equivalent circle diameter of crystal grains of a piezoelectric ceramic is 0.5 µm or more and 20 µm or less, such a piezoelectric ceramic may be suitably used for producing a piezoelectric element. Note that the term "average equivalent circle diameter" used herein refers to the average of the equivalent circle diameters of a plurality of crystal grains. The average equivalent circle diameter can be calculated by processing photographic images of the surface of the piezoelectric ceramic, which are taken with an optical microscope or a scanning electron microscope. An optical microscope and an electron microscope may be used appropriately depending on the diameter of the grains to be measured because the magnification suitable for the measurement differs depending on the diameter of the grains to be measured. Herein, the case where the average equivalent circle diameter exceeds 20 µm is considered as "abnormal grain growth"

The molar ratio of Na to Nb (Na/Nb) included in the raw material powder used for producing the piezoelectric ceramic according to the embodiment is preferably 0.95 or more and 1.10 or less. If the ratio Na/Nb in the raw material powder is less than 0.95, the ratio Na/Nb in the piezoelectric ceramic becomes less than 0.95, which causes the impurity phase to occur and consequently reduces the electromechanical coupling coefficient of the piezoelectric ceramic. If the ratio Na/Nb in the raw material powder exceeds 1.10, the ratio Na/Nb in the piezoelectric ceramic may exceed 1.05, which deteriorates the mechanical quality factor and insulating property of the piezoelectric ceramic compared with a sample in which the ratio Na/Nb is 1.05 or less.

The sintering temperature of the piezoelectric ceramic according to the embodiment is preferably 1200°C or less and is more preferably 1150°C or less. A sintering temperature exceeding 1200°C may reduce the density of the piezoelectric ceramic. The density of the piezoelectric ceramic can be measured on the basis of the Archimedes' principle. It is considered that the crystallization in the piezoelectric ceramic has occurred to a sufficient degree when the relative density of the piezoelectric ceramic, which is calculated by dividing the measured density of the piezoelectric ceramic by the theoretical density of the piezoelectric ceramic, is 94% or more. A sample having a relative density of less than 94% may have a lower electromechanical coupling coefficient than a sample having a relative density of 94% or more.

The sintering temperature is preferably 1200°C or more also from the viewpoint of the cost for manufacturing the piezoelectric element. In the case where a multilayer piezoelectric element that includes internal electrodes composed of an Ag/Pd paste is sintered at a temperature higher than 1200°C, the proportion of Pd needs to be increased to higher than 30% in order to enhance the heat resistance of the internal electrodes. An increase in the proportion of Pd, which is an expensive element, increases the cost for manufacturing the piezoelectric element considerably. A sintering temperature of 1200°C or less advantageously increases the density of the piezoelectric ceramic and permits inexpensive electrodes having low heat resistance to be used.

### Piezoelectric Element

A piezoelectric element according to an embodiment of the present invention is described below.

Fig. 1 is a diagram schematically illustrating a piezoelectric element according to the embodiment. The piezoelectric element according to the embodiment includes a first electrode 1, a piezoelectric material portion 2, and a second electrode 3. The piezoelectric material portion 2 includes the above-described piezoelectric ceramic.

The piezoelectric properties of the above-described piezoelectric ceramic can be evaluated when the piezoelectric ceramic is formed into a piezoelectric element that includes first and second electrodes. The first and second electrodes are conductive layers each having a thickness of about 5 nm to about 10 µm. The material for the conductive layers is not particularly limited, and any material commonly used for producing piezoelectric elements may be used. Examples of such a material include metals such as Ti, Pt, Ta, Ir, Sr, In, Sn, Au, Al, Fe, Cr, Ni, Pd, Ag, and Cu and compounds of these metals.

The first and second electrodes may include only one substance selected from the above-described metals and compounds or two or more substances selected from the above-described metals in the form of a multilayer body. The first and second electrodes may include different materials.

A method for forming the first and second electrodes is not limited. The first and second electrodes may be formed by baking of a metal paste, sputtering, or vapor deposition. The first and second electrodes may optionally be patterned in a desired shape.

### Poling Treatment

The directions of spontaneous polarization in the piezoelectric element are more preferably aligned in one direction. When the directions of spontaneous polarization in the piezoelectric element are aligned in one direction, the piezoelectric element has a large piezoelectric constant.

A method for poling the piezoelectric element is not particularly limited. Poling treatment may be performed in the air or silicone oil. The temperature at which poling treatment is performed is preferably 60°C to 150°C. However, the optimum conditions for performing poling treatment may differ slightly depending on the composition of the piezoelectric ceramic that constitutes the piezoelectric element. The electric field applied for performing poling treatment is preferably 10 to 30 kV/cm.

### Resonance-Antiresonance Method

The piezoelectric constant and mechanical quality factor of the piezoelectric element can be calculated from the results of measuring resonance frequency and antiresonance frequency using a commercially available impedance analyzer in accordance with a standard of the Japan Electronics and Information Technology Industries Association (JEITA EM-4501). Hereinafter, this method is referred to as "resonance-antiresonance method".

### Multilayer Piezoelectric Element

The multilayer piezoelectric element according to an embodiment of the present invention is described below.

The multilayer piezoelectric element according to the embodiment includes a plurality of piezoelectric ceramic layers and a plurality of electrode layers each including an internal electrode. The piezoelectric ceramic layers and the electrode layers are alternately stacked on top of one another. The piezoelectric ceramic layers each include the above-described piezoelectric ceramic.

Figs. 2A and 2B are schematic cross-sectional views of multilayer piezoelectric elements according to embodiments of the present invention. The multilayer piezoelectric element according to the embodiment includes piezoelectric ceramic layers that each include the above-described piezoelectric ceramic and electrode layers each including an internal electrode, which are alternately stacked on top of one another. The electrode layers may further include outer electrodes such as first and second electrodes.

Fig. 2A illustrates an example of the multilayer piezoelectric element according to the embodiment, which includes a multilayer body constituted by two piezoelectric ceramic layers 54 and one internal electrode 55 that are alternately stacked on top of one another and first and second electrodes 51 and 53 that pinch the multilayer body therebetween. The numbers of the piezoelectric ceramic layers and the internal electrodes may be increased as illustrated in Fig. 2B and are not limited. Another example of the multilayer piezoelectric element illustrated in Fig. 2B includes a multilayer body constituted by nine piezoelectric ceramic layers 504 and eight internal electrodes 505 (505a and 505b) that are alternately stacked on top of one another, first and second electrodes 501 and 503 that pinch the multilayer body therebetween, and outer electrodes 506a and 506b. The internal electrodes 505a and 505b, which are alternately formed, are short-circuited with the outer electrodes 506a and 506b, respectively.

The size and shape of the internal electrode 55 are not necessarily the same as those of the piezoelectric ceramic layer 54. The sizes and shapes of the internal electrodes 505 and the outer electrodes 506a and 506b are not necessarily the same as those of the piezoelectric ceramic layers 504. The internal electrodes 55 and 505 and the outer electrodes 506a and 506b may be each divided into a plurality of portions.

The internal electrodes 55 and 505, the outer electrodes 506a and 506b, the first electrodes 51 and 501, and the second electrodes 53 and 503 are conductive layers each having a thickness of about 5 nm to about 2000 nm. The material for the conductive layers is not particularly limited, and any material commonly used for producing piezoelectric elements may be used. Examples of such a material include metals such as Ti, Pt, Ta, Ir, Sr, In, Sn, Au, Al, Fe, Cr, Ni, Pd, Ag, and Cu and compounds of these metals. The internal electrodes 55 and 505 and the outer electrodes 506a and 506b may include only one substance selected from the above-described metals and compounds, a mixture or an alloy of two or more substances selected from the above-described metals and compounds, or two or more substances selected from the above-described metals and compounds in the form of a multilayer body. The plurality of electrodes may be composed of different materials.

The internal electrodes 55 and 505 may each include Ag and Pd, and the ratio M1/M2 of the weight M1 of Ag to the weight M2 of Pd included in each internal electrode is preferably 1.5 ≤ M1/M2 ≤ 9.0. If the weight ratio M1/M2 is less than 1.5, an increased Pd content increases the cost for preparing electrodes while the heat resistance of the internal electrodes is enhanced. If the weight ratio M1/M2 exceeds 9.0, the heatproof temperature of the internal electrodes becomes insufficiently low, which causes the internal electrodes to nonuniformly distribute in the multilayered piezoelectric element in an insular pattern. The ratio M1/M2 is more preferably 2.0 ≤ M1/M2 ≤ 5.0 from the viewpoints of heat resistance and cost.

The internal electrodes 55 and 505 preferably include at least one of Ni and Cu from the viewpoint of the cost of electrode materials. In such a case, the multilayer piezoelectric element according to the embodiment may be sintered in a reducing atmosphere.

The plurality of electrodes such as the internal electrodes 505 may be short-circuited to one another as illustrated in Fig. 2B in order to bring the driving voltages into phase with one another. For example, the internal electrodes 505a and the first electrode 501 may be short-circuited with the outer electrode 506a, and the internal electrodes 505b and the second electrode 503 may be short-circuited with the outer electrode 506b. The internal electrodes 505a and 505b may be disposed alternately. The method of short-circuiting the electrodes to one another is not limited. A short circuit may be established by, for example, forming electrodes or wires on the side surfaces of the multilayer piezoelectric element or by depositing conductive materials inside through holes formed in the piezoelectric material layers 504.

### Method for Producing Multilayer Piezoelectric Element

An example method for producing the above-described multilayer piezoelectric element is, but not limited to, the method described below, which includes the following steps:
Step (A): dispersing raw material powders of metal compounds including Na, Nb, Ba, Ti, Cu, and Mg to form a slurry;
Step (B): depositing the slurry on a substrate to form a compact;
Step (C): forming electrodes in the compact; and
Step (D): sintering the compact including the electrodes to prepare a multilayer piezoelectric element.

The term "powder" used herein refers to an assembly of solid particles. A "powder" may be an assembly of particles each including Na, Nb, Ba, Ti, Cu, and Mg or an assembly of a plural types of particles each including specific one or more elements selected from these elements.

The powder of a metal compound used in Step (A) above may be the powder of a Na compound, a Nb compound, a Ba compound, a Ti compound, a Cu compound, or a Mg compound. Examples of the Na compound include sodium carbonate and sodium niobate. Examples of the Nb compound include niobium oxide and sodium niobate. Examples of the Ba compound include barium oxide, barium carbonate, barium oxalate, barium acetate, barium nitrate, and barium titanate. Examples of the Ti compound include titanium oxide and barium titanate. Examples of the Cu compound include copper oxide, copper sulfate, and copper acetate. An example of the Mg compound is magnesium oxide.

The molar ratio of Na to Nb included in the raw material powder (Na/Nb) is preferably 0.95 or more and 1.10 or less. If the ratio Na/Nb in the raw material powder is less than 0.95, the ratio Na/Nb in the piezoelectric ceramic becomes less than 0.95, which causes the impurity phase to occur and consequently reduces electromechanical coupling coefficient. If the ratio Na/Nb in the raw material powder exceeds 1.10, the ratio Na/Nb in the piezoelectric ceramic may exceed 1.05. If the ratio Na/Nb in the piezoelectric ceramic exceeds 1.05, such a piezoelectric ceramic may have a lower mechanical quality factor and a poorer insulating property than a sample in which the ratio Na/Nb is 1.05 or less.

An example method for preparing the slurry in Step (A) above is described below. The powders of the above-described metal compounds are mixed in a solvent having a weight 1.6 to 1.7 times the weight of the powders. Examples of the solvent include toluene, ethanol, a mixed solvent of toluene and ethanol, n-butyl acetate, and water. After the powders and the solvent are mixed for 24 hours using a ball mill, a binder and a plasticizer are added to the resulting mixture. Examples of the binder include polyvinyl alcohol (PVA), polyvinyl butyral (PVB), and acrylic resins. In the case where PVB is used as a binder, the weight ratio between the solvent and PVB is set to, for example, 88:12. Examples of the plasticizer include dioctyl sebacate, dioctyl phthalate, and dibutyl phthalate. In the case where the plasticizer is dibutyl phthalate, the weight of the plasticizer is set to be equal to the weight of the binder. The mixture is further mixed using a ball mill overnight. The amounts of the solvent and the binder are controlled so that the viscosity of the slurry becomes 300 to 500 mPa·s.

The compact prepared in Step (B) above is a sheet-like mixture of the powders of metal compounds, the binder, and the plasticizer described above. An example method for preparing the compact in Step (B) above is sheet forming, which is conducted by a doctor blade method or the like. In a doctor blade method, the slurry is applied to the substrate with a doctor blade and dried to form a sheet-like compact. The substrate may be, for example, a PET film. A surface of the PET film on which the slurry is to be deposited may be coated with fluorine or the like in order to make it easy to remove the compact from the substrate. The deposited slurry may be dried by air-drying or hot-air drying. The thickness of the compact is not particularly limited and may be changed depending on the thickness of the multilayer piezoelectric element. The thickness of the compact can be increased by, for example, increasing the viscosity of the slurry.

A method for forming the electrodes, that is, the internal electrodes 505 and the outer electrodes 506a and 506b, in Step (C) above is not limited. These electrodes may be formed by, for example, baking of a metal paste, sputtering, vapor deposition, or printing. The thickness and pitch intervals of the piezoelectric ceramic layers 504 may be reduced in order to reduce driving voltage. In such a case, a multilayer body including precursors of the piezoelectric ceramic layers 504 and the internal electrodes 505a and 505b may be sintered at once. In the case where this process is selected, it is desirable to select a material of the internal electrodes so that the shape of the internal electrodes does not change and the conductivity of the internal electrodes does not become degraded due to the temperature required for sintering of the piezoelectric ceramic layers 504. The internal electrodes 505a and 505b and the outer electrodes 506a and 506b may be formed of a metal having a lower melting point and a lower price than Pt, such as Ag, Pd, Au, Cu, Ni, or an alloy thereof. Alternatively, the outer electrodes 506a and 506b may be formed after sintering of the multilayer body. In such a case, in addition to Ag, Pd, Cu, and Ni, Al and carbon-based electrode materials may also be used for forming the outer electrodes 506a and 506b.

The above-described electrodes may be formed by a screen printing method. In a screen printing method, a metal paste is applied to the compact disposed on the substrate using a spatula through a screen plate. A screen mesh is formed in at least a portion of the screen plate, and a metal paste deposited on the portion in which the screen mesh is formed is applied to the compact. The screen mesh formed in the screen plate may be patterned. By transferring the pattern to the compact using the metal paste, an electrode is formed on the compact in the pattern.

After the formation of the electrodes in Step (C) above, the compact is removed from the substrate and subsequently one or a plurality of the compacts stacked on top of one another is subjected to press-bonding. Examples of a press bonding method include uniaxial pressing, cold isostatic pressing, and hot isostatic pressing. A hot isostatic pressing is advantageous because it allows the multilayer body to be pressurized isotropically and uniformly. During press-bonding, the temperature may be increased at a temperature close to the glass transition temperature of the binder in order to increase the strength of press-bonding. A plurality of the compacts may be stacked on top of one another and then press-bonded in order to achieve the desired thickness. For example, a multilayer body of the compacts may be formed by stacking 10 to 100 layers of the compacts on top of one another and then thermocompression-bonding the resulting multilayer body at a pressure of 10 to 60 MPa at 50°C to 80°C for 10 seconds to 10 minutes in the direction in which the compacts are stacked. Putting alignment marks on the electrodes allows a plurality of the compacts to be stacked in alignment with high accuracy. Needless to say that forming a through hole for alignment in each compact also allows the compacts to be stacked with high accuracy.

The sintering temperature of the compact in Step (D) above is not particularly limited, but preferably a temperature at which all compounds included in the compact react and crystals grow to a sufficient degree. The sintering temperature is preferably 1200°C or less in order to set the diameter of grains of the piezoelectric ceramic within 1 to 20 µm. A multilayer piezoelectric element sintered in the above-described temperature range has good piezoelectric properties. In the case where the electrodes formed in Step (C) above are composed of a material including Ni as a main component, a furnace with which atmospheric sintering can be performed may be used in Step (D) above. After the binder is removed by burning in an air atmosphere at 200°C to 600°C, the atmosphere is changed to a reducing atmosphere, and sintering is performed at 1550°C or less and preferably 1200°C or less. The term "reducing atmosphere" used herein refers to an atmosphere that is a mixed gas mainly consisting of hydrogen (H₂) and nitrogen (N₂). The volume fraction of hydrogen to nitrogen is preferably H₂:N₂ = 1:99 to 10:90. The mixed gas may include oxygen. In such a case, the oxygen concentration is 10⁻¹² Pa or more and 10⁻⁴ Pa or less and is more preferably 10⁻⁸ Pa or more and 10⁻⁵ Pa or less. The oxygen concentration can be measured with a zirconia oxygen sensor. By using Ni electrodes, the multilayer piezoelectric element according to the embodiment can be produced at a low cost. After being sintered in a reducing atmosphere, the compact may be oxidized by replacing the atmosphere by an air atmosphere (i.e., oxidizing atmosphere) at a temperature reduced to 600°C. After the sintered body is removed from the sintering furnace, a conductive paste is applied to side surfaces of the sintered body at which the edges of the internal electrodes are exposed and then dried to form outer electrodes.

### Liquid Ejection Head

A liquid ejection head according to an embodiment of the present invention is described below.

The liquid ejection head according to the embodiment includes a liquid chamber including a vibrating portion in which the above-described piezoelectric element or the above-described multilayer piezoelectric element is disposed and an ejection port that communicates with the liquid chamber.

Figs. 3A and 3B are diagrams schematically illustrating the liquid ejection head according to the embodiment. As illustrated in Figs. 3A and 3B, the liquid ejection head according to the embodiment includes the above-described piezoelectric element 101. The piezoelectric element 101 includes a first electrode 1011, a piezoelectric material 1012, and a second electrode 1013. The piezoelectric material 1012 may be patterned as needed as illustrated in Fig. 3B.

Fig. 3B is a diagram illustrating the liquid ejection head according to the embodiment, which includes ejection ports 105, individual liquid chambers 102, communication holes 106 through which the respective individual liquid chambers 102 and the respective ejection ports 105 are communicated, liquid chamber partitions 104, a common liquid chamber 107, a vibrating plate 103, and a piezoelectric element 101. The shape of the piezoelectric element 101 is a rectangle in Fig. 3B, but may alternatively be an ellipse, a circle, a parallelogram, or the like. Generally, the piezoelectric ceramic 1012 has a shape substantially conforming to that of the individual liquid chamber 102.

A portion in the vicinity of the piezoelectric element 101 included in the liquid ejection head according to the embodiment is described in detail with reference to Fig. 3A. Fig. 3A is a cross-sectional view of the piezoelectric element illustrated in Fig. 3B which is taken in the width direction. The shape of the cross section of the piezoelectric element 101 illustrated in Fig. 3A is a rectangle, but may alternatively be a trapezoid or an inverted trapezoid.

In Fig. 3A, the first electrode 1011 serves as a lower electrode and the second electrode 1013 serves as an upper electrode. However, the arrangement of the first electrode 1011 and the second electrode 1013 is not limited to this. For example, the first electrode 1011 may serve as a lower electrode or an upper electrode. Similarly, the second electrode 1013 may serve as an upper electrode or a lower electrode. A buffer layer 108 may optionally be interposed between the vibrating plate 103 and the lower electrode. The electrodes described above have different names simply due to the different methods used for producing the device, and the advantageous effect of the embodiment can be achieved in any case.

In the liquid ejection head, the vibrating plate 103 is vibrated vertically due to the extension and contraction of the piezoelectric ceramic 1012, thereby applying pressure to liquid contained in the individual liquid chambers 102. Thus, liquid is ejected through the ejection ports 105. The liquid ejection head according to the embodiment may be used as a component of a printer or for producing electronic devices.

The thickness of the vibrating plate 103 is 1.0 µm or more and 15 µm or less and is preferably 1.5 µm or more and 8 µm or less. The material for the vibrating plate is preferably, but not limited to, Si. Si included in the vibrating plate may be doped with boron or phosphorus. The buffer layer and the electrode layers formed on the vibrating plate may be incorporated into the vibrating plate. The thickness of the buffer layer 108 is 5 nm or more and 300 nm or less and is preferably 10 nm or more and 200 nm or less. The size of the ejection ports 105 is 5 µm or more and 40 µm or less in terms of equivalent circle diameter. The shape of the ejection ports 105 may be a circle, a star, a rectangle, or a triangle.

### Liquid Ejecting Apparatus

A liquid ejecting apparatus according to an embodiment of the present invention is described below. The liquid ejecting apparatus according to the embodiment includes a recording-medium transportation section and the above-described liquid ejection head. The liquid ejecting apparatus according to the embodiment includes a receiver-supporting portion and the above-described liquid ejection head.

An example of the liquid ejecting apparatus according to the embodiment is the ink-jet recording apparatus illustrated in Figs. 4 and 5. Fig. 5 illustrates a portion of the liquid ejecting apparatus 881 (ink-jet recording apparatus) illustrated in Fig. 4 from which exterior components 882 to 885 and 887 have been removed. The ink-jet recording apparatus 881 includes an automatic feeding section 897 through which a recording paper that serves as a receiver is automatically fed inside an apparatus main body 896; a transportation section 899 that serves as a receiver-supporting portion, through which the recording paper fed through the automatic feeding section 897 is guided to a predetermined recording position and then to a discharge port 898; a recording section 891 in which the recording paper transported to the recording position is recorded; and a recovery section 890 in which recovery of the recording section 891 is performed. The recording section 891 includes a carriage 892 that includes the above-described liquid ejection head and is reciprocated along a rail.

In the above-described ink-jet recording apparatus, an electrical signal sent from a computer causes the carriage 892 to reciprocate along the rail, and application of a driving voltage between the electrodes that pinch a piezoelectric ceramic therebetween causes the piezoelectric ceramic to deform. By using the deformation of the piezoelectric material, pressure is applied to the individual liquid chambers 102 with the vibrating plate 103 interposed between the piezoelectric material and the individual liquid chambers 102 as illustrated in Fig. 3B. This causes ink to be ejected through the ejection ports 105 to perform recording.

The liquid ejecting apparatus according to the embodiment allows liquid to be ejected uniformly at high speeds. Furthermore, the size of the liquid ejecting apparatus may be reduced.

The liquid ejecting apparatus according to the embodiment is described above taking a printer as an example. However, the liquid ejecting apparatus according to the embodiment may also be used as an ink-jet recording apparatus such as a facsimile, a multifunction machine, or a copying machine or as an industrial liquid-ejecting apparatus.

In addition, the liquid ejecting apparatus according to the embodiment allows a user to select a receiver suitable for the application. The liquid ejecting apparatus according to the embodiment may be configured so that the liquid ejection head moves relatively to a receiver placed on a stage that serves as the supporting portion.

### Ultrasonic Motor

An ultrasonic motor according to an embodiment of the present invention is described below. The ultrasonic motor according to the embodiment includes a vibrating body in which the above-described piezoelectric element or the above-described multilayer piezoelectric element is disposed and the moving body in contact with the vibrating body.

Figs. 6A and 6B are diagrams schematically illustrating examples of the ultrasonic motor according to the embodiment. Fig. 6A illustrates an example of the ultrasonic motor according to the embodiment in which the piezoelectric element is constituted by a single layer. This ultrasonic motor includes a vibrator 201, a rotor 202 pressed into contact with a sliding surface of the vibrator 201 by a pressure spring (not shown in the drawing), and an output shaft 203 provided integrally with the rotor 202. The vibrator 201 includes an elastic metal ring 2011, the above-described piezoelectric element 2012, and an organic adhesive 2013 (e.g., epoxy-based adhesive or cyanoacrylate-based adhesive) with which the piezoelectric element 2012 is bonded to the elastic ring 2011. The piezoelectric element 2012 includes first and second electrodes and a piezoelectric ceramic interposed therebetween (not shown in the drawing).

Upon two alternating voltages that are an odd multiple of π/2 apart in phase with each other being applied to the piezoelectric element, a progressive wave is generated in the vibrator 201, which causes every point on the sliding surface of the vibrator 201 to move in an elliptic orbit. The rotor 202, which is pressed into contact with the sliding surface of the vibrator 201, experiences a frictional force from the vibrator 201, and thereby rotates in a direction opposite to the direction of the progressive wave. A body to be driven (not shown in the drawing) is joined to the output shaft 203 and driven due to the rotational force of the rotor 202.

Upon a voltage being applied to the piezoelectric ceramic, the piezoelectric ceramic expands and contracts due to the transverse piezoelectric effect. The expansion and contraction of the piezoelectric ceramic causes the elastic body such as a metal which is joined to the piezoelectric element to bend. This type of an ultrasonic motor described above utilizes the above-described principle.

Fig. 6B illustrates another example of the ultrasonic motor according to the embodiment, which includes a piezoelectric element having a multilayer structure. A vibrator 204 includes a cylindrical elastic metal body 2041 and a multilayer piezoelectric element 2042 interposed between the upper and lower part of the elastic body 2041. The multilayer piezoelectric element 2042 includes a multilayer body constituted by a plurality of piezoelectric ceramics stacked on top of one another (not shown in the drawing), first and second electrodes disposed on the outer surface of the multilayer body, and internal electrodes disposed on the inner surface of the multilayer body. An end of the elastic metal body 2041 is fastened with a bolt, thereby fixing the multilayer piezoelectric element 2042 between the upper and lower parts of the elastic metal body 2041. Thus, a vibrator 204 is formed.

Upon alternating voltages that are apart in phase with each other being applied to the multilayer piezoelectric element 2042, two oscillations that are orthogonal to each other are excited in the vibrator 204. The two oscillations are combined into a circular oscillation, which drives the edge portion of the vibrator 204. The upper part of the vibrator 204 is narrowed to form a peripheral groove therein, which increases the amplitude of the oscillation for driving.

The rotor 205 is pressed into contact with the vibrator 204 by a pressure spring 206, and thereby a frictional force for driving is applied to the rotor 205. The rotor 205 is rotatably supported by a bearing.

### Optical Device

An optical device according to an embodiment of the present invention is described below. The optical device according to the embodiment includes a driving section including the above-described ultrasonic motor.

Figs. 7A and 7B are cross-sectional views of principal parts of an interchangeable lens barrel for single-lens reflex cameras, which is an example of the optical device according to the embodiment. Fig. 8 is an exploded perspective view of an interchangeable lens barrel for single-lens reflex cameras, which is an example of the optical device according to the embodiment. A fixed barrel 712, a straight guide barrel 713, and a front lens group barrel 714 are fixed to a mount 711 detachably attachable to a camera. These components are fixed members of the interchangeable lens barrel.

A straight guide groove 713a is formed in the straight guide barrel 713 in the optical-axis direction for guiding a focus lens 702. The focus lens 702 is supported by a rear lens group barrel 716, to which cam rollers 717a and 717b protruding outward in the radial direction are fixed using a screw 718. The cam roller 717a fits into the straight guide groove 713a.

A cam ring 715 rotatably fits to the inner periphery of the straight guide barrel 713. A roller 719 fixed to the cam ring 715 fits into the peripheral groove 713b of the straight guide barrel 713, thereby limiting the relative displacement between the straight guide barrel 713 and the cam ring 715 in the optical-axis direction. A cam groove 715a for the focus lens 702 is formed in the cam ring 715. The above-described cam roller 717b fits into the cam groove 715a.

A rotation transmission ring 720 is disposed on the outer periphery-side of the fixed barrel 712. The rotation transmission ring 720 is supported by a ball race 727 rotatably at a fixed position relative to the fixed barrel 712. A wheel 722 is rotatably supported by a shaft 720f that extends spokewise from the rotation transmission ring 720. A large-diameter portion of the wheel 722 is in contact with a mount-side surface 724b of a manual focus ring 724. A small-diameter portion 722b of the wheel 722 is in contact with a joint 729. The wheel 722 is disposed at six positions on the outer periphery of the rotation transmission ring 720 at regular intervals, and each wheel is arranged in the above-described manner.

A low-friction sheet (washer) 733 is disposed on the inner periphery of the manual focus ring 724. The low-friction sheet is interposed between a mount-side surface 712a of the fixed barrel 712 and a front surface 724a of the manual focus ring 724. The outer periphery of the low-friction sheet 733 has a ring-like shape and fits to an inner periphery 724c of the manual focus ring 724. The inner periphery 724c of the manual focus ring 724 fits to an outer periphery 712b of the fixed barrel 712. The low-friction sheet 733 reduces a frictional force that occurs in a ring rotation system in which the manual focus ring 724 rotates around the optical-axis direction relatively to the fixed barrel 712.

The large-diameter portion 722a of the wheel 722 and the mount-side surface 724b of the manual focus ring 724 are brought into contact with each other by a certain pressure caused by a wave washer 726 pressing an ultrasonic motor 725 forward of the lenses. The small-diameter portion 722b of the wheel 722 and the joint 729 are also brought into contact with each other by an adequate pressure caused by the wave washer 726 pressing the ultrasonic motor 725 forward of the lenses. The movement of the wave washer 726 in the direction of the mount is limited by a washer 732 joined to the fixed barrel 712 by a bayonet mechanism. The spring force exerted by the wave washer 726 is transferred to the ultrasonic motor 725 and then the wheels 722, and thereby the manual focus ring 724 presses the mount-side surface 712a of the fixed barrel 712. In other words, the manual focus ring 724 is arranged so as to press the mount-side surface 712a of the fixed barrel 712 with the low-friction sheet 733 interposed therebetween.

When the ultrasonic motor 725 is rotated relative to the fixed barrel 712 using a controlling section (not shown in the drawing), the wheels 722 are rotated around the respective shafts 720f due to the frictional contact between the joint 729 and the small-diameter portions 722b of the wheels 722. The wheels 722 rotating around the respective shafts 720f cause the rotation transmission ring 720 to rotate around the optical axis (automatic focusing).

When a rotational force is applied to the manual focus ring 724 around the optical axis through a manual input section (not shown in the drawing), the wheels 722 are rotated around the respective shafts 720f due to a frictional force between the mount-side surface 724b of the manual focus ring 724 and the large-diameter portions 722a of the wheels 722, which are pressed into contact with each other. The rotation of the large-diameter portions 722a of the wheels 722 around the shaft 720f cause the rotation transmission ring 720 to rotate around the optical axis. Note that, in this state, the ultrasonic motor 725 is held by a frictional force between a rotor 725c and a stator 725b so as not to rotate (manual focusing).

Two focus keys 728 are disposed on the rotation transmission ring 720 at opposite positions and fit into a notch portion 715b formed in the edge of the cam ring 715. Thus, when the rotation transmission ring 720 is rotated around the optical axis in automatic focusing or manual focusing, the resulting rotational force is transmitted to the cam ring 715 through the focus keys 728. When the cam ring 715 is rotated around the optical axis due to the rotational force, the rear lens group barrel 716, whose rotation is limited by the cam roller 717a and the straight guide groove 713a, is moved forward or backward by the cam roller 717b along the cam groove 715a of the cam ring 715. In the above-described manner, the focus lens 702 is operated in order to achieve focusing.

Although the optical device according to the embodiment is described taking an interchangeable lens barrel for single-lens reflex cameras as an example, the optical device according to the embodiment may also be used as an optical device that includes a driving section that includes an ultrasonic motor regardless of the types of camera, such as a compact camera and an electronic still camera.

### Vibrating Apparatus And Dust-Removing Apparatus

Vibrating apparatuses are used for, for example, transporting or removing particles, powders, or liquid and are also widely employed in electronic devices and the like. The vibrating apparatus according to an embodiment of the present invention is described below taking, as an example, a dust-removing apparatus that includes the above-described piezoelectric element.

The vibrating apparatus according to the embodiment includes a vibrating body that includes a vibrating plate on which the above-described piezoelectric element or the above-described multilayer piezoelectric element is disposed. The dust-removing apparatus according to the embodiment includes a vibrating body that includes a vibrating plate on which the above-described piezoelectric element or the above-described multilayer piezoelectric element is disposed.

Figs. 9A and 9B are diagrams schematically illustrating the dust-removing apparatus according to the embodiment. A dust-removing apparatus 310 includes piezoelectric elements 330 having a tabular shape and a vibrating plate 320. The piezoelectric element 330 may be the above-described multilayer piezoelectric element. The material for the vibrating plate 320 is not limited. In the case where the dust-removing apparatus 310 is used in an optical device, the vibrating plate 320 may be composed of a translucent material or a light-reflecting material.

Figs. 10A to 10C are diagrams schematically illustrating the piezoelectric element 330 illustrated in Figs. 9A and 9B. Figs. 10A and 10C illustrate the front and rear surfaces of the piezoelectric element 330, respectively. Fig. 10B illustrates the side surface of the piezoelectric element 330. As shown in Figs. 9A to 10C, the piezoelectric element 330 includes a piezoelectric ceramic 331, a first electrode 332, and a second electrode 333. The first electrode 332 and the second electrode 333 are disposed on the respective main surfaces of the piezoelectric ceramic 331. The piezoelectric element 330 may be the above-described multilayer piezoelectric element as in Figs. 9A and 9B. In such a case, the piezoelectric ceramic 331 has a structure in which piezoelectric material layers and internal electrodes are alternately stacked on top of one another, and the internal electrodes are alternately short-circuited to the first electrode 332 and the second electrode 333. This allows driving waveforms that are apart in phase with each other to be inputted to the piezoelectric ceramic layers. The term "first electrode surface 336" used herein refers to a surface of the piezoelectric element 330 on which the first electrode 332 is disposed and which is illustrated on the front side in Fig. 10C. The term "second electrode surface 337" used herein refers to a surface of the piezoelectric element 330 on which the second electrode 333 is disposed and which is illustrated on the front side in Fig. 10A.

The term "electrode surface" used herein refers to a surface of the piezoelectric element on which the electrode is disposed. For example, the first electrode 332 may extend to the second electrode plane 337 as shown in Fig. 10B.

The first electrode surface 336 of the piezoelectric element 330 is adhered to the main surface of the vibrating plate 320 as illustrated in Figs. 9A and 9B. Upon operation of the piezoelectric elements 330, a stress is caused between each piezoelectric element 330 and the vibrating plate 320, which causes out-of-plane oscillation of the vibrating plate. The dust-removing apparatus 310 according to the embodiment removes foreign matter such as dust which is adhered to the surface of the vibrating plate 320 by using the out-of-plane oscillation of the vibrating plate 320. The term "out-of-plane oscillation" used herein refers to elastic oscillation that causes the vibrating plate to displace in the optical-axis direction, that is, the thickness direction of the vibrating plate.

Figs. 11A and 11B are diagrams schematically illustrating the principle of vibration of the dust-removing apparatus 310 according to the embodiment. Fig. 11A illustrates the vibrating plate 320 in which out-of-plane oscillation is caused by applying alternating voltages that are in phase with each other to the pair of the piezoelectric elements 330. The piezoelectric ceramic constituting the pair of the piezoelectric elements 330 is poled in the direction same as the thickness direction of the piezoelectric element 330. The dust-removing apparatus 310 is operated in the seventh oscillation mode. Fig. 11B illustrates the vibrating plate 320 in which the out-of-plane oscillation is caused by applying alternating voltages that are in reverse phase with each other (i.e., the phase difference between the alternating voltages is 180°) to the pair of the piezoelectric elements 330. The dust-removing apparatus 310 is operated in the sixth oscillation mode. By using at least two different oscillation modes, the dust-removing apparatus 310 according to the embodiment removes dust adhered to the surface of the vibrating plate with effect.

### Imaging Apparatus

An imaging apparatus according to an embodiment of the present invention is described below. The imaging apparatus according to the embodiment includes the above-described dust-removing apparatus and an imaging-element unit. The vibrating plate of the dust-removing apparatus is disposed on a light-receiving-side surface of the imaging-element unit. Figs. 12 and 13 are diagrams illustrating a digital single-lens reflex camera, which is an example of the imaging apparatus according to the embodiment.

Fig. 12 is a front perspective view of the camera main body 601 without a camera lens unit, which is viewed from a subject. Fig. 13 is a schematic exploded perspective view of the inside of the camera for explaining the structure surrounding the dust-removing apparatus and an imaging unit 400.

A photographic light flux that passed through camera lenses is guided to a mirror box 605 disposed inside the camera main body 601. A main mirror (instant-return mirror) 606 is disposed inside the mirror box 605 at the following two positions: at an angle of 45° with respect to the photographic optical axis in order to guide the photographic light flux toward a pentamirror (not shown in the drawing); and at a position apart from the photographic light flux in order to guide the photographic light flux toward an imaging element (not shown in the drawing).

The mirror box 605 and a shutter unit 200, in the order of the distance from the subject, are disposed on the subject-side of a main body chassis 300, which serves as the framework of the camera main body 601. An imaging unit 400 is disposed on the photographer-side of the main body chassis 300. The imaging unit 400 is arranged so that an imaging surface of an imaging element is arranged parallel to an attachment surface of a mount portion 602, which serves as a reference for attaching the camera lens unit, at a predetermined spacing.

The imaging apparatus -according to the embodiment is described above taking a digital single-lens reflex camera as an example. However, the imaging apparatus according to the embodiment may also be a camera lens unit-interchangeable camera, such as a mirrorless digital single-lens reflex camera that does not include the mirror box 605. The imaging apparatus according to the embodiment may also be used as a video camera with interchangeable camera lens unit, any imaging apparatus such as copying machine, a facsimile, or a scanner or in electrical and electric devices that include an imaging apparatus and, in particular, that require removal of dust adhered to the surface of an optical component.

### Electronic Device

An electronic device according to an embodiment of the present invention is described below. The electronic device according to the embodiment includes a piezoelectric acoustic component that includes the above-described piezoelectric element or the above-described multilayer piezoelectric element. Examples of the piezoelectric acoustic component include a speaker, a buzzer, a microphone, and a surface acoustic wave (SAW) element.

Fig. 14 is a front perspective view of a main body 931 of a digital camera, which is an example of the electronic device according to the embodiment. The main body 931 includes an optical apparatus 901, a microphone 914, a stroboscopic light-emitting section 909, and an assist-beam section 916 disposed on the front surface thereof. The microphone 914 is indicated by a broken line since it is incorporated inside the main body 931. The main body 931 has a hole formed forward of the microphone 914 in order to collect an external sound through the hole.

The main body 931 also includes a power button 933, a speaker 912, a zoom lever 932, and a release button 908 that are disposed on the upper surface thereof. Focusing is achieved using the release button 908. The speaker 912 is indicated by a broken line since it is incorporated inside the main body 931. The main body 931 has apertures formed above the speaker 912 in order to transmit sound outward through the apertures.

The piezoelectric acoustic component according to the embodiment may be used as at least one component selected from the microphone 914, the speaker 912, and the surface acoustic wave element.

The electronic device according to the embodiment is described above taking a digital camera as an example. However, the electronic device according to the embodiment may also be used as any electronic device that includes a piezoelectric acoustic component, such as a sound-reproduction device, a sound-recording device, a mobile phone, or an information terminal device.

As described above, the piezoelectric element and multilayer piezoelectric element according to embodiments of the present invention may be suitably used in a liquid ejection head, a liquid ejecting apparatus, an ultrasonic motor, an optical device, a vibrating apparatus, a dust-removing apparatus, an imaging apparatus, or an electronic device.

By using the piezoelectric element or multilayer piezoelectric element according to an embodiment of the present invention, a liquid ejection head having a nozzle density and an ejection speed that are comparable to or higher than those of a piezoelectric element containing lead may be provided.

By using the liquid ejection head according to an embodiment of the present invention, a liquid ejecting apparatus capable of ejecting liquid at a speed and an accuracy that are comparable to or higher than those of a liquid ejecting apparatus that includes a piezoelectric element containing lead may be provided.

By using the piezoelectric element or multilayer piezoelectric element according to an embodiment of the present invention, an ultrasonic motor having a driving force and durability that are comparable to or higher than those of an ultrasonic motor that includes a piezoelectric element containing lead may be provided.

By using the ultrasonic motor according to an embodiment of the present invention, an optical device having durability and operating accuracy that are comparable to or higher than those of an optical device that includes a piezoelectric element containing lead may be provided.

By using the piezoelectric element or multilayer piezoelectric element according to an embodiment of the present invention, a vibrating apparatus having a vibrating force and durability that are comparable to or higher than those of a vibrating apparatus that includes a piezoelectric element containing lead may be provided.

By using the vibrating apparatus according to an embodiment of the present invention, a dust-removing apparatus having a dust removal efficiency and durability that are comparable to or higher than those of a dust-removing apparatus that includes a piezoelectric element containing lead may be provided.

By using the dust-removing apparatus according to an embodiment of the present invention, an imaging apparatus having a dust removal capability comparable to or higher than that of an imaging apparatus that includes a piezoelectric element containing lead may be provided.

By using the piezoelectric acoustic component that includes the piezoelectric element or multilayer piezoelectric element according to an embodiment of the present invention, an electronic device having a sound-producing capability comparable to or higher than that of an electronic device that includes a piezoelectric element containing lead may be provided.

The piezoelectric ceramic according to an embodiment of the present invention may be used for producing a liquid ejection head, a motor, and various devices such as an ultrasonic vibrator, a piezoelectric actuator, a piezoelectric sensor, and a ferroelectric memory.

### Examples

The piezoelectric ceramic according to an embodiment of the present invention is described more in detail with reference to examples below. However, the present invention is not limited to the examples below.

Piezoelectric ceramics and their intermediate products prepared in Examples and Comparative Examples were prepared and evaluated in the following steps.

### Comparative Examples 1 and 2

A comparative piezoelectric ceramic that did not contain Cu was prepared. In Comparative Example 1, raw material powders were weighed so that the composition of the comparative piezoelectric ceramic was
(Na_{0.88}Ba_{0.12})(Nb_{0.88}Ti_{0.12})O₃. In Comparative Example 2, raw material powders were weighed so that the amount of MgO included in the comparative piezoelectric ceramic was 0.2 mol% of the amount (1 mol) of a perovskite-type metal oxide (Na_{0.88}Ba_{0.12})(Nb_{0.88}Ti_{0.12})O₃. The raw material powders used were a sodium niobate (NaNbO₃) powder, a barium titanate (BaTiO₃) powder, and a magnesium oxide (MgO) powder. The purities of the sodium niobate, barium titanate, and magnesium oxide powders were 99% or more, 99% or more, and 99.99% or more, respectively. The molar ratio of Na to Nb included in the sodium niobate powder was 1.00 ± 0.05 as measured by atomic absorption spectrometry and an ICP emission spectrochemical analysis. Ethanol and zirconia balls were added to the weighed raw material powders, and the resulting mixture was wet-milled for 24 hours. Subsequently, the mixture was filtered through a sieve to remove the zirconia balls. The resulting slurry containing ethanol was dried in a drying furnace kept at 80°C. Then, a binder was added to the resulting mixture of the raw material powders to granulate the mixture of the raw material powders. The granulated powder was charged in a metal mold and compacted to prepare a compact having a diameter of 17 mm and a thickness of about 1 mm. The compact was sintered in the air at a maximum temperature of 1100°C for 6 hours to prepare a ceramic (hereinafter, also referred to as "sample"). Measurement of the sample by X-ray diffraction confirmed that the sample had a perovskite structure as a main phase.

### Comparative Example 3

A comparative piezoelectric ceramic that did not contain Mg was prepared. In Comparative Example 3, the comparative piezoelectric ceramic was prepared as in Comparative Example 1 except that cupper oxide (CuO) was used for preparing the comparative piezoelectric ceramic. Specifically, the amount of CuO included in the comparative piezoelectric ceramic was 0.5 mol% of the amount (1 mol) of a perovskite-type metal oxide (Na_{0.88}Ba_{0.12})(Nb_{0.88}Ti_{0.12})O₃. The purity of the cupper oxide powder was 99% or more. Measurement of the sample by X-ray diffraction confirmed that the sample had a perovskite structure substantially as a single phase. The density of the sintered body was 94% or more of the theoretical density. Fig. 15A is an image of the surface of the comparative piezoelectric ceramic prepared in Comparative Example 3, which is taken using an optical microscope at 20-fold magnification. The average equivalent circle diameter of crystal grains of the sample exceeded 20 µm. That is, it was confirmed that abnormal grain growth had occurred.

### Comparative Example 4

The ratio of Na to Nb in the raw material powders was changed to less than 0.95 by adding niobium oxide (Nb₂O₅) to the raw material powders in order to prepare a comparative piezoelectric ceramic having a ratio Na/Nb of less than 0.95. Specifically, the comparative piezoelectric ceramic was prepared as in Comparative Example 1, except that the raw material powders were weighed so that the amounts of CuO, MgO, and NbO_{2.5} included in the comparative piezoelectric ceramic were 0.5 mol%, 1 mol%, and 6 mol%, respectively, of the amount (1 mol) of a perovskite-type metal oxide (Na_{0.88}Ba_{0.12})(Nb_{0.88}Ti_{0.12})O₃. The purity of the niobium oxide powder was 99% or more. Measurement of the sample by X-ray diffraction confirmed that the sample included an impurity phase. The ratio Na/Nb in the ceramic was 0.93 as measured by wavelength-dispersive X-ray fluorescence (XRF) spectrometry. The measurement by XRF spectrometry was conducted using calibration curves determined from reference samples having known compositions determined by atomic absorption spectrometry and an ICP emission spectrochemical analysis.

### Comparative Example 5

The ratio of Na to Nb included in the raw material powders was changed to more than 1.1 by adding sodium carbonate (Na₂CO₃) to the raw material powders in order to prepare a comparative piezoelectric ceramic having a ratio Na/Nb exceeding 1.05. Specifically, the comparative piezoelectric ceramic was prepared as in Comparative Example 1, except that the raw material powders were weighed so that the amounts of CuO, MgO, and NaO_{0.5} included in the comparative piezoelectric ceramic were 0.5 mol%, 1 mol%, and 10 mol%, respectively, of the amount (1 mol) of a perovskite-type metal oxide (Na_{0.88}Ba_{0.12})(Nb_{0.88}Ti_{0.12})O₃. The purity of the sodium carbonate powder was 99% or more. Measurement of the sample by X-ray diffraction confirmed that the sample included a perovskite structure as a main phase. The ratio Na/Nb in the ceramic was 1.06 as measured by XRF spectrometry.

### Examples 1 to 6

A piezoelectric ceramic according to an embodiment of the present invention was prepared as in Comparative Example 3, except that MgO was used for preparing the piezoelectric ceramics. Specifically, raw material powders were weighed so that the amount of MgO included in the piezoelectric ceramic was 0.1 mol% (Example 1), 0.2 mol% (Example 2), 0.5 mol% (Example 3), 0.75 mol% (Example 4), 1.0 mol% (Example 5), or 2.0 mol% (Example 6) of the amount (1 mol) of a perovskite-type metal oxide (Na_{0.88}Ba_{0.12})(Nb_{0.88}Ti_{0.12})O₃. Measurement of the sintered piezoelectric ceramic by X-ray diffraction conducted confirmed that the sample included a perovskite structure as a main phase. The density of the piezoelectric ceramic was 94% or more of the theoretical density. Note that, the expression "0.50 mol%" used for Cu content in Example 1 means that 0.398 g of copper oxide (0.318 g in terms of Cu) was used relative to 1 mol (172.2 g) of the perovskite-type metal oxide represented by General Formula (1). The ratio Na/Nb in the raw material powders was 1.05 as measured by XRF spectrometry.

Both surfaces of each of the pellet-like piezoelectric ceramics prepared in Examples 1 to 6 were ground to a thickness of 0.5 mm. Gold electrodes were formed on the respective surfaces of each piezoelectric ceramic by DC sputtering to form the piezoelectric element according to an embodiment of the present invention. The piezoelectric elements were cut into a strip of 10 mm × 2.5 mm × 0.5 mm, which was used for evaluating the properties of the piezoelectric ceramic. The piezoelectric ceramics prepared in Comparative Examples 1 to 5 were also processed into comparative piezoelectric elements as in Examples 1 to 6, which were used for evaluating the properties of the piezoelectric ceramics. Each sample was subjected to poling treatment prior to the evaluation of piezoelectric properties by a resonance-antiresonance method. Specifically, after each sample was heated to 150°C in an oil bath, an electric field of 20 kV/cm was applied to the sample for 30 minutes. While applying the voltage to the sample, the sample was cooled to room temperature.

Table 1 summarizes the Curie temperature (Tc), relative dielectric constant, electromechanical coupling coefficient (k₃₁), piezoelectric constant (d₃₁), Young's modulus (Y₁₁), and mechanical quality factor (Qₘ) of the piezoelectric element prepared from each of the piezoelectric ceramics prepared in Examples 1 to 6 and the comparative piezoelectric ceramics prepared in Comparative Examples 1 to 5. The relative dielectric constant of each piezoelectric element was measured by applying an alternating voltage to the strip-like piezoelectric element at a frequency of 1 kHz and a voltage of 0.5 V. The electromechanical coupling coefficient, piezoelectric constant, Young's modulus, and mechanical quality factor of each piezoelectric element were measured by a resonance-antiresonance method. Table 1 also summarizes the molar ratio (x/y) of Na to Nb and the CuO and MgO contents relative to the content of the perovskite-type metal oxide, which were determined by XRF after grinding the surface of the piezoelectric ceramic. Because the CuO amount was likely to decrease by 20% to 40% from the originally weighed amount after sintering, the Cu raw material was weighed to be excessive so as to achieve the composition shown in Table 1. Deviation of the ratio x/y of each sample from 1 resulted from deviation of the ratio Na/Nb in the NaNbO₃ raw material powder used from 1 or volatilization of Na during sintering, except for Comparative Examples 4 and 5 where Nb and Na were intentionally added, respectively. The description in Tables 3 and 4 regarding the composition is the same as in Table 1.

Table 1 shows that the comparative piezoelectric elements prepared in Comparative Examples 1 and 2, which did not include CuO, had a significantly low relative dielectric constant, a significantly low electromechanical coupling coefficient, and a significantly low piezoelectric constant and that the samples prepared in Examples 1 to 6 had an improved mechanical quality factor compared with Comparative Examples 1 to 3.

An triangular-wave electric field was applied to each strip-like piezoelectric element at a frequency of 10 Hz to measure a polarization-electric field hysteresis curve. Table 2 summarizes the average of the magnitudes of coercive electric fields and the magnitude of internal electric field determined from the hysteresis curve. Table 2 shows that the addition of MgO increased the average of the magnitudes of coercive electric fields and the magnitude of internal electric field.

It was confirmed that, the sample prepared in Comparative Example 4, in which the ratio (x/y) of the Na content x to the Nb content y was less than 0.95, had a lower electromechanical coupling coefficient than the sample prepared in Example 5, in which the ratio x/y fell within the range according to an embodiment of the present invention. It was also confirmed that, the sample prepared in Comparative Example 5, in which the ratio (x/y) of the Na content x to the Nb content y exceeded 1.05, had a lower mechanical quality factor than the sample prepared in Example 5, in which the ratio x/y fell within the range according to an embodiment of the present invention.

### [Table 1]

**[Table 1]**

| Sample No. | (NaₓBa_{1-y})(Nb_{y}Ti_{1-y})O₃ | | | CuO (mol%) | MgO (mol%) | Curie temperature Tc (°C) | Relative dielectric constant εᵣ (-) | Electromechanical coupling coefficient k₃₁ (-) | Piezoelectric Young's constant modulus \|d₃₁\| (pm/V) Y₁₁ (GPa) | | Mechanical quality factor Qₘ (-) |
|---|---|---|---|---|---|---|---|---|---|---|---|
| | x | y | x/y | | | | | | | | |
| Comparative example 1 | 0.88 | 0.88 | 1.00 | 0 | 0 | 190 | 667 | 0.06 | 16 | 83 | 329 |
| Comparative example 2 | 0.89 | 0.88 | 1.01 | 0 | 0.20 | 190 | 621 | 0.04 | 10 | 88 | 377 |
| Comparative example 3 | 0.90 | 0.88 | 1.02 | 0.50 | 0 | 190 | 941 | 0.19 | 46 | 137 | 472 |
| Example 1 | 0.88 | 0.88 | 1.00 | 0.50 | 0.10 | 190 | 927 | 0.19 | 47 | 134 | 538 |
| Example 2 | 0.89 | 0.88 | 1.01 | 0.50 | 0.20 | 190 | 1052 | 0.19 | 51 | 133 | 546 |
| Example 3 | 0.90 | 0.88 | 1.02 | 0.50 | 0.50 | 190 | 1002 | 0.18 | 46 | 133 | 597 |
| Example 4 | 0.91 | 0.88 | 1.03 | 0.50 | 0.75 | 190 | 973 | 0.18 | 45 | 132 | 652 |
| Example 5 | 0.88 | 0.88 | 1.00 | 0.50 | 1.00 | 190 | 957 | 0.17 | 42 | 131 | 701 |
| Example 6 | 0.88 | 0.88 | 1.00 | 0.50 | 2.00 | 190 | 944 | 0.16 | 40 | 131 | 750 |
| Comparative example 4 | 0.83 | 0.89 | 0.93 | 0.50 | 1.00 | 190 | 744 | 0.14 | 33 | 117 | 315 |
| Comparative example 5 | 0.93 | 0.88 | 1.06 | 0.50 | 1.00 | 190 | 980 | 0.16 | 42 | 126 | 562 |

**[Table 2]**

| Sample No. | Average magnitude of coercive electric field (\|+Ec\|+\|-Ec\|)/2 (kV/cm) | Internal electric field Ed (kV/cm) |
|---|---|---|
| Comparative example 3 | 14.6 | -1.99 |
| Example 2 | 16.2 | -1.86 |
| Example 3 | 16.4 | -2.32 |
| Example 4 | 16.9 | -2.57 |
| Example 5 | 16.3 | -3.26 |

Figs. 15A to 15C are optical microscope images of the surfaces of the piezoelectric ceramics prepared in Comparative Example 3, Example 1, and Example 2, respectively. The surfaces of the sintered bodies were observed using an optical microscope in order to evaluate the size of grains of the sintered bodies. It was confirmed that the grains of the sintered bodies prepared in Comparative Example 3 (Fig. 15A) and Example 1 (Fig. 15B) were abnormally grown. The abnormal grain growth was not observed in the sintered bodies prepared in Examples 2 (Fig. 15C) to 6, which had an average equivalent circle diameter of 0.5 to 20 µm. Thus, it was confirmed that adding MgO at a content of 0.2 mol% or more increases mechanical quality factor and suppresses the occurrence of the abnormal grain growth compared with a case where MgO was not used. A piezoelectric ceramic having an average equivalent circle diameter of 0.5 to 20 µm may be suitably used for producing a device. The size of small crystal grains was determined using a scanning electron microscope (SEM). The average equivalent circle diameter of the crystal grains was calculated on the basis of the observation results and considered to be the average grain size of the crystal grains.

### Comparative Examples 6, 8, and 9

A comparative piezoelectric ceramic in which the Na content x or the Nb content y was 0.85 or less or more than 0.92 was sintered at 1175°C. The contents of Cu and Mg in the comparative piezoelectric ceramic were set to 0.1 mol% and 0.5 mol%, respectively. The piezoelectric ceramics of Comparative Examples 6, 8, and 9 were prepared as in Example 1, except that the sintering temperature and the amounts of raw material powders weighed were changed.

### Comparative Example 7

A comparative piezoelectric ceramic that did not contain Mg was sintered at 1175°C. The content of Cu in the comparative piezoelectric ceramic was set to 0.1 mol%. The piezoelectric ceramic of Comparative Example 7 was prepared as in Comparative Example 3, except that the sintering temperature and the amounts of raw material powders weighed were changed.

### Examples 7 to 12

A piezoelectric ceramic according to an embodiment of the present invention in which the Na content x and the Nb content y were 0.85 or more and 0.92 or less was sintered at 1175°C. The contents of Cu and Mg in the piezoelectric ceramic were set to 0.1 mol% and 0.5 mol%, respectively. The piezoelectric ceramics of Examples 7 to 12 were prepared as in Example 1, except that the sintering temperature and the amounts of raw material powders weighed were changed.

The piezoelectric ceramics prepared in Examples 7 to 12 and the comparative piezoelectric ceramics prepared in Comparative Examples 6 to 9 were evaluated as in Examples 1 to 6. The relative dielectric constants of the samples were measured using an impedance analyzer by changing the temperature of the samples from -100°C to 350°C while applying an alternating voltage to the samples at a voltage of 0.5 V and a frequency of 1 kHz. On the basis of the temperature dependence of the relative dielectric constant of each sample, the Curie temperature of the sample, at which the relative dielectric constant of the sample was locally maximized due to the phase transition from the tetragonal phase to the cubic phase, was determined. Depending on the composition of the sample, a temperature at which an inflection point of relative dielectric constant due to the phase transition from the orthorhombic phase to the tetragonal phase was observed. For example, although a sample having a composition (Na_{0.90}Ba_{0.10})(Nb_{0.90}Ti_{0.10})O₃ had a Curie temperature of about 210°C, an inflection point of the relative dielectric constant of the sample which is due to the phase transition from the orthorhombic phase to the tetragonal phase was observed around 20°C. The samples used for measuring Curie temperature were samples that had not yet been subjected to poling treatment.

Table 3 summarizes the relative dielectric constant, electromechanical coupling coefficient (k₃₁), piezoelectric constant (d₃₁), Young's modulus (Y₁₁), mechanical quality factor (Qₘ), and the molar ratio (x/y) of Na to Nb of the piezoelectric element prepared from each of the piezoelectric ceramics prepared in Examples 7 to 12 and the comparative piezoelectric ceramics prepared in Comparative Examples 6 to 9. The measurement conditions were the same as in Table 1. Table 3 shows that a piezoelectric ceramic having a Na content x or Nb content y of less than 0.85 has a low Curie temperature of less than 120°C and is of little practical use (Comparative Example 6). Since the piezoelectric ceramic prepared in Comparative Example 6 had a low Curie temperature of 60°C, it was impossible to perform the poling treatment of the piezoelectric ceramic at 150°C. Therefore, in Comparative Example 6, evaluation of piezoelectric properties was not made. The symbol "-" in Table 3 indicates that the measurement of resonance frequency and antiresonance frequency was not done. It was also confirmed that a piezoelectric ceramic having a Na content x or Nb content y of more than 0.92, has a significantly low piezoelectric constant (Comparative Examples 8 and 9). The sample prepared in Comparative Example 7, which did not contain MgO, had a lower mechanical quality factor than the sample prepared in Example 11, which contained MgO.

### [Table 3]

**[Table 3]**

| Sample No. | (NaₓBa_{1-y})(Nb_{y}Ti_{1-y})O₃ | | | CuO (mol%) | MgO (mol%) | Curie temperature Tc (°C) | Relative dielectric constant εᵣ (-) | Electromechanical coupling coefficient k₃₁ (-) | Young's modulus Y₁₁ (GPa) | Piezoelectric constant \|d₃₁\| (pm/V) | Mechanical quality factor Qₘ (-) |
|---|---|---|---|---|---|---|---|---|---|---|---|
| | x | y | x/y | | | | | | | | |
| Comparative example 6 | 0.82 | 0.80 | 1.02 | 0.10 | 0.50 | 60 | - | - | - | - | - |
| Example 7 | 0.86 | 0.85 | 1.01 | 0.10 | 0.50 | 160 | 1087 | 0.19 | 122 | 54 | 499 |
| Example 8 | 0.90 | 0.88 | 1.02 | 0.10 | 0.50 | 190 | 1089 | 0.21 | 133 | 56 | 507 |
| Example 9 | 0.86 | 0.88 | 0.98 | 0.10 | 0.50 | 190 | 1121 | 0.21 | 126 | 58 | 552 |
| Example 10 | 0.89 | 0.90 | 0.99 | 0.10 | 0.50 | 210 | 1109 | 0.21 | 132 | 57 | 538 |
| Example 11 | 0.90 | 0.90 | 1.00 | 0.10 | 0.50 | 210 | 996 | 0.20 | 127 | 53 | 642 |
| Comparative example 7 | 0.90 | 0.90 | 1.00 | 0.10 | 0.00 | 210 | 1004 | 0.19 | 127 | 51 | 415 |
| Example 12 | 0.92 | 0.92 | 1.00 | 0.10 | 0.50 | 240 | 930 | 0.19 | 129 | 48 | 594 |
| Comparative example 8 | 0.95 | 0.95 | 1.00 | 0.10 | 0.50 | 290 | 274 | 0.17 | 136 | 23 | 653 |
| Comparative example 9 | 0.97 | 0.97 | 1.00 | 0.10 | 0.50 | 293 | 287 | 0.14 | 136 | 19 | 710 |

### Examples 13 to 21

A piezoelectric ceramic according to an embodiment of the present invention was prepared as in Example 1, except that the sintering temperature and the amounts of raw material powders weighed were changed.

The piezoelectric ceramics prepared in Examples 13 to 21 were evaluated as in Examples 1 to 6. Table 4 summarizes the sintering temperature and the density of the piezoelectric element prepared from each of the piezoelectric ceramics prepared in Examples 2, 3, 5, 6, and 13 to 21.

The density of each sample was measured on the basis of the Archimedes' principle prior to grinding of the sample. Since the theoretical density of (Na_{0.88}Ba_{0.12})(Nb_{0.88}Ti_{0.12})O₃ is 4.69 g/cm³, the relative density of the sample is 94% or more when the density of the sample measured is 4.41 g/cm³ or more. The crystal phase of each piezoelectric ceramic was evaluated by an X-ray diffraction measurement.

Table 4 shows that the piezoelectric ceramics prepared in Examples 13 to 16, which were sintered at 1200°C, had a lower density (less than 94% of the theoretical density) than the piezoelectric ceramics according to an embodiment of the present invention, which were prepared at 1150°C or 1100°C.

### [Table 4]

**[Table 4]**

| Sample No. | (NaₓBa_{1-y})(Nb_{y}Ti_{1-y})O₃ | | | CuO (mol%) | MgO (mol%) | Sintering temperature (°C) | Density (g/cm³) |
|---|---|---|---|---|---|---|---|
| | X | y | x/y | | | | |
| Example 13 | 0.90 | 0.88 | 1.02 | 0.50 | 0.20 | 1200 | 4.33 |
| Example 14 | 0.88 | 0.88 | 1.00 | 0.50 | 0.50 | 1200 | 4.38 |
| Example 15 | 0.89 | 0.88 | 1.01 | 0.50 | 1.00 | 1200 | 4.35 |
| Example 16 | 0.90 | 0.88 | 1.02 | 0.50 | 2.00 | 1200 | 4.37 |
| Example 17 | 0.86 | 0.88 | 0.98 | 0.50 | 0.20 | 1150 | 4.47 |
| Example 18 | 0.87 | 0.88 | 0.99 | 0.50 | 0.50 | 1150 | 4.45 |
| Example 19 | 0.88 | 0.88 | 1.00 | 0.50 | 1.00 | 1150 | 4.42 |
| Example 20 | 0.92 | 0.88 | 1.04 | 0.50 | 2.00 | 1150 | 4.41 |
| Example 2 | 0.89 | 0.88 | 1.01 | 0.50 | 0.20 | 1100 | 4.52 |
| Example 3 | 0.90 | 0.88 | 1.02 | 0.50 | 0.50 | 1100 | 4.51 |
| Example 5 | 0.91 | 0.88 | 1.03 | 0.50 | 1.00 | 1100 | 4.47 |
| Example 6 | 0.88 | 0.88 | 1.00 | 0.50 | 2.00 | 1100 | 4.45 |
| Example 21 | 0.90 | 0.88 | 1.02 | 1.00 | 0.50 | 1100 | 4.51 |

### Example 22

The same raw material powders were wet-milled at the same blending proportions as in Example 2, and the resulting raw material mixture was dried. An organic binder was mixed with the raw material mixture, and the resulting mixture was formed into a sheet by a doctor blade method. Thus, a green sheet having a thickness of 50 µm was formed.

A conductive paste for internal electrodes was printed on the green sheet. The conductive paste used was an alloy of 70% Ag and 30% Pd. Nine green sheets on which the conductive paste was deposited were stacked on top of one another, and the resulting multilayer body was sintered at 1100°C to prepare a sintered body. The sintered body was cut into a piece of 10 mm × 2.5 mm. The side surfaces the piece were ground, and a pair of outer electrodes, that is, first and second electrodes, were formed on the respective side surfaces by Au sputtering so that internal electrodes were alternately short-circuited with the pair of outer electrodes. Thus, a multilayer piezoelectric element as illustrated in Fig. 2B was prepared.

Observation of the internal electrodes of the multilayer piezoelectric element confirmed that layers made of an Ag-Pd alloy, that is, electrode material, and piezoelectric material layers were alternately stacked on top of one another.

The sample was subjected to poling treatment prior to the evaluation of piezoelectric properties. Specifically, the sample was heated to 150°C on a hot plate, an electric field of 20 kV/cm was applied between the first and second electrodes for 30 minutes, and the sample was cooled to room temperature while the electric field was applied to the sample.

Evaluation of the piezoelectric properties of the sample confirmed that the sample had a sufficiently good insulating property. Thus, it was confirmed that the sample had piezoelectric properties comparable to those of the piezoelectric ceramic prepared in Example 2.

### Example 23

A liquid ejection head as illustrated in Figs. 3A and 3B was prepared using the piezoelectric element prepared in Example 2. It was confirmed that the liquid ejection head ejected ink in accordance with an inputted electrical signal.

### Example 24

A liquid ejecting apparatus as illustrated in Fig. 4 was prepared using the liquid ejection head prepared in Example 23. It was confirmed that the liquid ejecting apparatus ejected ink onto a receiver in accordance with an inputted electrical signal.

### Example 25

An ultrasonic motor as illustrated in Fig. 6A was prepared using the piezoelectric element prepared in Example 2. It was confirmed that the ultrasonic motor rotated in accordance with an applied alternating voltage.

### Example 26

An optical device as illustrated in Fig. 7A was prepared using the ultrasonic motor prepared in Example 25. It was confirmed that the optical device achieved automatic focusing in accordance with an applied alternating voltage.

### Example 27

A dust-removing apparatus as illustrated in Figs. 9A and 9B was prepared using the piezoelectric element prepared in Example 2. Plastic beads were spread, and an alternating voltage was applied to the dust-removing apparatus. It was confirmed that the dust-removing apparatus removed dust with a high efficiency.

### Example 28

An imaging apparatus as illustrated in Fig. 12 was prepared using the dust-removing apparatus prepared in Example 27. It was confirmed that dust adhered on the surface of the imaging unit of the imaging apparatus was adequately removed and, as a result, the imaging apparatus formed images without failures caused due to the dust.

### Example 29

An electronic device as illustrated in Fig. 14 was prepared using the piezoelectric element prepared in Example 2. It was confirmed that the speaker of the electronic device was operated in accordance with an applied alternating voltage.

### Example 30

A liquid ejection head as illustrated in Figs. 3A and 3B was prepared using the multilayer piezoelectric element prepared in Example 22. It was confirmed that the liquid ejection head ejected ink in accordance with an inputted electrical signal.

### Example 31

A liquid ejecting apparatus as illustrated in Fig. 4 was prepared using the liquid ejection head prepared in Example 30. It was confirmed that the liquid ejecting apparatus ejected ink onto a receiver in accordance with an inputted electrical signal.

### Example 32

An ultrasonic motor as illustrated in Fig. 6B was prepared using the multilayer piezoelectric element prepared in Example 22. It was confirmed that the ultrasonic motor rotated in accordance with an applied alternating voltage.

### Example 33

An optical device as illustrated in Fig. 7A was prepared using the ultrasonic motor prepared in Example 32. It was confirmed that the optical device achieved automatic focusing in accordance with an applied alternating voltage.

### Example 34

A dust-removing apparatus as illustrated in Figs. 9A and 9B was prepared using the multilayer piezoelectric element prepared in Example 22. Plastic beads were spread, and an alternating voltage was applied to the dust-removing apparatus. It was confirmed that the dust-removing apparatus removed dust with a high efficiency.

### Example 35

An imaging apparatus as illustrated in Fig. 12 was prepared using the dust-removing apparatus prepared in Example 34. It was confirmed that dust adhered on the surface of the imaging unit of the imaging apparatus was adequately removed and, as a result, the imaging apparatus formed images without failures caused due to the dust.

### Example 36

An electronic device as illustrated in Fig. 14 was prepared using the multilayer piezoelectric element prepared in Example 22. It was confirmed that the speaker of the electronic device was operated in accordance with an applied alternating voltage.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

This application claims the benefit of Japanese Patent Application No. 2014-014471, filed January 29, 2014, which is hereby incorporated by reference herein in its entirety.

### Industrial Applicability

The piezoelectric ceramic according to an embodiment of the present invention has good piezoelectric properties even at a high environmental temperature and has a low environmental load since it does not contain lead. Thus, the lead-free piezoelectric ceramic according to the embodiment can be suitably used for producing devices in which piezoelectric ceramics are commonly used, such as a liquid ejection head, an ultrasonic motor, and a dust-removing apparatus.

## Claims

1. A piezoelectric ceramic comprising:
a perovskite-type metal oxide represented by General Formula (1):
General Formula (1) : (NaₓBa_{1-y})(Nb_{y}Ti_{1-y})O₃,
where 0.85 ≤ x ≤ 0.92, 0.85 ≤ y ≤ 0.92, and 0.95 ≤ x/y ≤ 1.05;
CuO; and
MgO,
wherein a content of CuO is 0.1 mol% or more and 1 mol% or less and a content of MgO is 0.1 mol% or more and 2 mol% or less of a content of the perovskite-type metal oxide.

2. The piezoelectric ceramic according to Claim 1,
wherein an average of equivalent circular diameters of crystal grains constituting the piezoelectric ceramic is 0.5 µm or more and 20 µm or less.

3. A method for producing the piezoelectric ceramic according to Claim 1, the method comprising:
sintering a raw material powder including Na, Nb, Ba, Ti, Cu, and Mg,
wherein the molar ratio of Na to Nb included in the raw material powder is 0.95 ≤ Na/Nb ≤ 1.10.

4. The method according to Claim 3, for producing the piezoelectric ceramic according to Claim 1,
wherein a sintering temperature is 1200°C or less.

5. A piezoelectric element comprising:
a first electrode;
a piezoelectric material portion; and
a second electrode,
wherein the piezoelectric material portion includes the piezoelectric ceramic according to Claim 1 or 2.

6. A multilayer piezoelectric element comprising:
a plurality of piezoelectric ceramic layers; and
a plurality of electrode layers each including an internal electrode,
the piezoelectric ceramic layers and the electrode layers being alternately stacked on top of one another,
wherein the piezoelectric ceramic layers each include the piezoelectric ceramic according to Claim 1 or 2.

7. The multilayer piezoelectric element according to Claim 6,
wherein the internal electrode includes Ag and Pd, and
wherein a ratio M1/M2 of a weight M1 of Ag to a weight M2 of Pd is 1.5 ≤ M1/M2 ≤ 9.0.

8. The multilayer piezoelectric element according to Claim 6,
wherein the internal electrode includes at least one element selected from Ni and Cu.

9. A liquid ejection head comprising:
a liquid chamber including a vibrating portion in which the piezoelectric element according to Claim 5 or the multilayer piezoelectric element according to any one of Claims 6 to 8 is disposed; and
an ejection port communicating with the liquid chamber.

10. A liquid ejecting apparatus comprising:
a recording-medium transportation section; and
the liquid ejection head according to Claim 9.

11. An ultrasonic motor comprising:
a vibrating body in which the piezoelectric element according to Claim 5 or the multilayer piezoelectric element according to any one of Claims 6 to 8 is disposed; and
a moving body in contact with the vibrating body.

12. An optical device comprising:
a driving section including the ultrasonic motor according to Claim 11.

13. A vibrating apparatus comprising:
a vibrating body including a vibrating plate on which the piezoelectric element according to Claim 5 or the multilayer piezoelectric element according to any one of Claims 6 to 8 is disposed.

14. A dust-removing apparatus comprising:
a vibrating portion including the vibrating apparatus according to Claim 13.

15. An imaging apparatus comprising:
the dust-removing apparatus according to Claim 14; and
an imaging-element unit,
wherein the vibrating plate of the dust-removing apparatus is disposed on a light-receiving-side surface of the imaging-element unit.

16. An electronic device comprising a piezoelectric acoustic component comprising:
the piezoelectric element according to Claim 5 or the multilayer piezoelectric element according to any one of Claims 6 to 8.

## Patentansprüche

1. Piezoelektrische Keramik, umfassend:
ein durch allgemeine Formel (1) dargestelltes Metalloxid vom Perowskittyp:
Allgemeine Formel (1): (NaₓBa_{1-y})(Nb_{y}Ti_{1-y})O₃,
wobei 0,85 ≤ x ≤ 0,92; 0,85 ≤ y ≤ 0,92; und 0,95 ≤ x/y ≤ 1,05;
CuO; und
MgO,
wobei ein Gehalt an CuO 0,1 Mol% oder mehr und 1 Mol% oder weniger und ein Gehalt an MgO 0,1 Mol% oder mehr und 2 Mol% oder weniger bezüglich eines Gehalts des Metalloxids vom Perowskittyp beträgt.

2. Piezoelektrische Keramik nach Anspruch 1,
wobei ein Durchschnitt von Äquivalentkreisdurchmessern der Kristallkörner, welche die piezoelektrische Keramik bilden, 0,5 *µ*m oder mehr und 20 *µ*m oder weniger beträgt.

3. Verfahren zum Herstellen der piezoelektrischen Keramik nach Anspruch 1, umfassend:
Sintern eines Rohmaterialpulvers, das Na, Nb, Ba, Ti, Cu, und Mg enthält,
wobei das Molverhältnis von im Rohmaterialpulver enthaltenem Na zu Nb 0,95 ≤ Na/Nb ≤ 1,10 beträgt.

4. Verfahren nach Anspruch 3 zum Herstellen der piezoelektrischen Keramik nach Anspruch 1,
wobei eine Sintertemperatur 1200°C oder weniger beträgt.

5. Piezoelektrisches Element, umfassend:
eine erste Elektrode;
einen Abschnitt aus piezoelektrischem Material; und
eine zweite Elektrode,
wobei der Abschnitt aus piezoelektrischem Material die piezoelektrische Keramik nach Anspruch 1 oder Anspruch 2 enthält.

6. Mehrschichtiges piezoelektrisches Element, umfassend:
mehrere Schichten piezoelektrischer Keramik, und
mehrere Elektrodenschichten, die jeweils eine Innenelektrode enthalten;
wobei die Schichten piezoelektrischer Keramik und die Elektrodenschichten abwechselnd aufeinander gestapelt sind; und
wobei die Schichten piezoelektrischer Keramik jeweils die piezoelektrische Keramik nach Anspruch 1 oder 2 enthalten.

7. Mehrschichtiges piezoelektrisches Element nach Anspruch 6,
wobei die Innenelektrode Ag und Pd enthält, und
wobei ein Verhältnis M1/M2 einer Masse M1 von Ag zu einer Masse M2 von Pd 1,5 ≤ M1/M2 ≤ 9,0 beträgt.

8. Mehrschichtiges piezoelektrisches Element nach Anspruch 6,
wobei die Innenelektrode mindestens ein aus Ni und Cu ausgewähltes Element enthält.

9. Flüssigkeitsausstoßkopf, umfassend:
eine Flüssigkeitskammer, die einen Schwingungsabschnitt enthält, in dem das piezoelektrische Element nach Anspruch 5 oder das mehrschichtige piezoelektrische Element nach einem der Ansprüche 6 bis 8 angeordnet ist; und
eine mit der Flüssigkeitskammer kommunizierende Ausstoßöffnung.

10. Flüssigkeitsausstoßvorrichtung, umfassend:
einen Abschnitt zum Transportieren eines Aufzeichnungsmediums, und
den Flüssigkeitsausstoßkopf nach Anspruch 9.

11. Ultraschallmotor, umfassend:
einen Schwingungskörper, in dem das piezoelektrische Element nach Anspruch 5 oder das mehrschichtige piezoelektrische Element nach einem der Ansprüche 6 bis 8 angeordnet ist; und
einen Bewegungskörper, der sich in Kontakt mit dem Schwingungskörper befindet.

12. Optische Einrichtung, umfassend:
einen Antriebsabschnitt, der den Ultraschallmotor nach Anspruch 11 enthält.

13. Schwingungsvorrichtung, umfassend:
einen Schwingungskörper, der eine Schwingungsplatte enthält, auf der das piezoelektrische Element nach Anspruch 5 oder das mehrschichtige piezoelektrische Element nach einem der Ansprüche 6 bis 8 angeordnet ist.

14. Staubentfernungsvorrichtung, umfassend:
einen Schwingungsabschnitt, der die Schwingungsvorrichtung nach Anspruch 13 enthält.

15. Bildgebungsvorrichtung, umfassend:
die Staubentfernungsvorrichtung nach Anspruch 14, und
eine Bildgebungselementeinheit,
wobei die Schwingungsplatte der Staubentfernungsvorrichtung auf einer lichtempfangsseitigen Fläche der Bildgebungselementeinheit angeordnet ist.

16. Elektronische Vorrichtung, die eine piezoelektrische akustische Komponente umfasst, welche umfasst:
das piezoelektrische Element nach Anspruch 5 oder das mehrschichtige piezoelektrische Element nach einem der Ansprüche 6 bis 8.

## Revendications

1. Céramique piézoélectrique comprenant :
un oxyde métallique de type pérovskite représenté par la Formule Générale (1) :
Formule Générale (1) : (NaₓBa_{1-y})(Nb_{y}Ti_{1-y})O₃,
où 0,85 ≤ x ≤ 0,92, 0,85 ≤ y ≤ 0,92 et 0,95 ≤ x/y ≤ 1,05 ;
CuO ; et
MgO,
où une teneur en CuO est supérieure ou égale à 0,1 % en mole et inférieure ou égale à 1 % en mole et une teneur en MgO est supérieure ou égale à 0,1 % en mole et inférieure ou égale à 2 % en mole d'une teneur en oxyde métallique de type pérovskite.

2. Céramique piézoélectrique selon la revendication 1, dans laquelle une moyenne de diamètres circulaires équivalents des grains cristallins constituant la céramique piézoélectrique est supérieure ou égale à 0,5 µm et inférieure ou égale à 20 µm.

3. Procédé de production de la céramique piézoélectrique selon la revendication 1, le procédé comprenant :
le frittage d'une poudre de matière première comportant Na, Nb, Ba, Ti, Cu et Mg,
dans lequel le rapport molaire de Na sur Nb inclus dans la poudre de matière première est 0,95 ≤ Na/Nb ≤ 1,10.

4. Procédé selon la revendication 3, pour la production de la céramique piézoélectrique selon la revendication 1, dans lequel la température de frittage est inférieure ou égale à 1200°C.

5. Élément piézoélectrique comprenant :
une première électrode ;
une partie de matériau piézoélectrique ; et
une deuxième électrode,
dans lequel la partie de matériau piézoélectrique comporte la céramique piézoélectrique selon la revendication 1 ou 2.

6. Élément piézoélectrique multicouche comprenant :
une pluralité de couches de céramique piézoélectrique ; et
une pluralité de couches d'électrode comportant chacune une électrode interne,
les couches de céramique piézoélectrique et les couches d'électrode étant empilées en alternance les unes sur les autres,
dans lequel les couches de céramique piézoélectrique comportent chacune la céramique piézoélectrique selon la revendication 1 ou 2.

7. Élément piézoélectrique multicouche selon la revendication 6,
dans lequel l'électrode interne comporte Ag et Pd, et
dans lequel un rapport M1/M2 d'un poids M1 d'Ag sur un poids M2 de Pd est 1,5 ≤ M1/M2 ≤ 9,0.

8. Élément piézoélectrique multicouche selon la revendication 6, dans lequel l'électrode interne comporte au moins un élément choisi parmi Ni et Cu.

9. Tête d'éjection de liquide comprenant :
une chambre de liquide comportant une partie vibrante dans laquelle l'élément piézoélectrique selon la revendication 5 ou l'élément piézoélectrique multicouche selon l'une quelconque des revendications 6 à 8 est disposé ; et
un orifice d'éjection communiquant avec la chambre de liquide.

10. Appareil d'éjection de liquide comprenant :
une section de transport de support d'enregistrement ; et
la tête d'éjection de liquide selon la revendication 9.

11. Moteur à ultrasons comprenant :
un corps vibrant dans lequel l'élément piézoélectrique selon la revendication 5 ou l'élément piézoélectrique multicouche selon l'une quelconque des revendications 6 à 8 est disposé ; et
un corps mobile en contact avec le corps vibrant.

12. Dispositif optique comprenant :
une section d'entraînement comportant le moteur à ultrasons selon la revendication 11.

13. Appareil vibrant comprenant :
un corps vibrant comportant une plaque vibrante sur laquelle l'élément piézoélectrique selon la revendication 5 ou l'élément piézoélectrique multicouche selon l'une quelconque des revendications 6 à 8 est disposé.

14. Appareil de dépoussiérage comprenant :
une partie vibrante comportant l'appareil vibrant selon la revendication 13.

15. Appareil d'imagerie comprenant :
l'appareil de dépoussiérage selon la revendication 14 ; et
une unité d'élément d'imagerie,
dans lequel la plaque vibrante de l'appareil de dépoussiérage est disposée sur une surface côté réception de lumière de l'unité d'élément d'imagerie.

16. Dispositif électronique comprenant un composant acoustique piézoélectrique qui comprend :
l'élément piézoélectrique selon la revendication 5 ou l'élément piézoélectrique multicouche selon l'une quelconque des revendications 6 à 8.
